# EUROPEAN PATENT APPLICATION

(11) **EP 2 073 279 A1**
(43) Date of publication of application: **24.06.2009**
(21) Application number: 07807693.2
(22) Date of filing: 21.09.2007
(51) Int. Cl.: H01L 31/042

(54) **SOLAR CELL, LIGHT CONCENTRATING PHOTOVOLTAIC POWER GENERATION MODULE, LIGHT CONCENTRATING PHOTOVOLTAIC POWER GENERATION UNIT, SOLAR CELL MANUFACTURING METHOD AND SOLAR CELL MANUFACTURING APPARATUS**

(30) Priority: 28.09.2006 JP 2006265167; 29.09.2006 JP 2006268191; 31.01.2007 JP 2007022026
(71) Applicant: Sharp Kabushiki Kaisha, Osaka-shi, Osaka 545-8522 (JP)
(72) Inventor: NAKAMURA, Kenta, Nara 639-0223 (JP); YANG, Minju, Nara 635-0014 (JP); INOUE, Shingo, Nara 634-0072 (JP)
(74) Representative: Müller - Hoffmann & Partner
(86) International application number: PCT/JP2007/068343
(87) International publication number: WO 2008/041502

(57) **Abstract**

A solar cell (10) according to one embodiment of the present invention includes a concentrating solar cell element (11) that generates power by converting sunlight (Ls) into electricity; and a receiver substrate (20) on which the solar cell element (11) is placed. A covering portion (30) that covers and protects the solar cell element (11) is formed on the receiver substrate (20). The covering portion (30) includes a U-shaped sealing frame (31) that is formed on a surface of the receiver substrate (20), has an opening (31s), and surrounds the periphery of the solar cell element (11) at a position away from the periphery; a light-transmitting covering plate (32) that is bonded to the sealing frame (31) and covers the solar cell element (11); and a resin sealing portion (33) in which a sealing region defined by the sealing frame (31) and the light-transmitting covering plate (32) is filled with sealing resin.

## Description

### Technical Field

The present invention relates to a solar cell including a solar cell element and a receiver substrate on which the solar cell element is placed or a solar cell in which a light-shielding portion that prevents damage on members due to sun tracking error or the like, a concentrating solar power generation module including such a solar cell, a concentrating solar power generation unit including a solar cell mounting plate on which such a solar cell is mounted, a method of manufacturing such a solar cell, and a solar cell manufacturing apparatus that produces such a solar cell.

### Background Art

While solar power generation apparatuses (solar power generation units) which convert solar energy into electric power are in practical use, in order to achieve cost reduction and provide a large amount of electric power, concentrating solar power generation apparatuses (concentrating solar power generation units), a type of solar cell that provides electric power by irradiating a solar cell element having a light-receiving area smaller than that of a concentrating lens with sunlight concentrated by the concentrating lens are coming into practical use.

Because a concentrating solar power generation apparatus concentrates sunlight with the concentrating lens and irradiates the solar cell element with the sunlight, it is only necessary that the solar cell element includes a small light-receiving area capable of receiving the sunlight concentrated by the optical system. That is, the solar cell element can be smaller in size than the light-receiving area of the concentrating lens, so the size of solar cell element can be reduced, and the number of solar cell elements, which are expensive components, used in the solar power generation apparatus can be reduced, resulting in a cost reduction. With these advantages, concentrating solar power generation apparatuses are coming into use as electric power supplies in areas where a broad area can be used for power generation.

A concentrating solar power generation apparatus has been proposed that can provide sufficient strength, rigidity and heat dissipation properties with a simple configuration in which a solar cell module is attached to a support plate, without causing an increase in weight (see, for example, Patent Document 1)

As element properties, the photoelectric conversion efficiency of a solar cell element is improved as concentration magnification is increased. However, if the position of the solar cell element remains fixed, most sunlight enters obliquely, failing to make efficient use of the sunlight. In view of this, a sun-tracking concentrating solar power generation apparatus has been proposed that has a high concentration magnification and that is configured to track the sun so as to always receive sunlight at the front face.

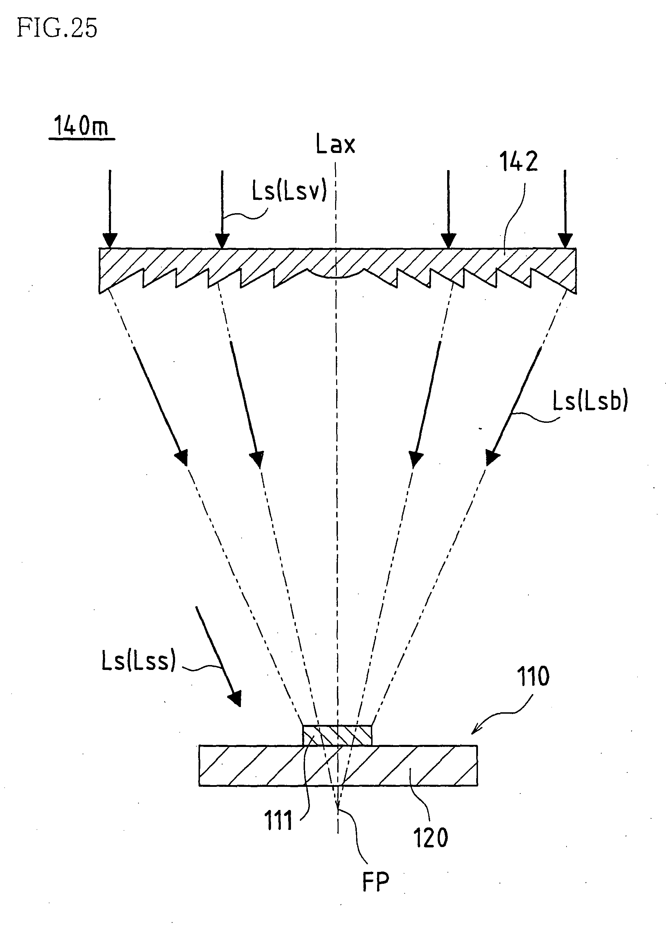

FIG. 25 is a cross-sectional view of a configuration of a concentrating solar power generation module that is applied to a conventional sun-tracking concentrating solar power generation apparatus.

A concentrating solar power generation module 140m according to a conventional example includes a concentrating lens 142 that receives and concentrates sunlight Ls (sunlight Lsv) and a solar cell 110 that converts the sunlight Ls (sunlight Lsb) concentrated by the concentrating lens 142 into electricity. The solar cell 110 includes a solar cell element 111 that converts the sunlight Ls (sunlight Lsb) concentrated by the concentrating lens 142 into electricity and a receiver substrate 120 on which the solar cell element 111 is placed. The concentrating lens 142 is configured to have a focal position FP on the back side of the solar cell element 111.

The conventional sun-tracking concentrating solar power generation apparatus utilizes the concentrating solar power generation module 140m, which can provide a high concentration magnification through the action of the concentrating lens 142.

A sun-tracking concentrating solar power generation apparatus with a high concentration magnification concentrates sunlight Ls, so very highly accurate sun tracking is required. In reality, however, alignment errors between the concentrating lens 142 and the solar cell element 111, positional offset caused by the difference in temperature properties between the members that constitute the concentrating solar power generation module 140m, and the like occur, so the apparatus has a problem in that the actual amount of light incident on the solar cell element 111 decreases, reducing the electric power (output) generated by the solar cell element 111.

There is also another problem in that when a region other than the solar cell element 111 is irradiated with deviated sunlight Ls (sunlight Lss), the thermal energy of the deviated sunlight Lss heats the members of the irradiated portion (for example, insulating film, wiring, etc.) to a high temperature, causing burnout (breakage) in some cases.

In order to solve such problems, ordinarily, a secondary optical system is provided between the concentrating lens and the solar cell element.

Specifically, a structure in which a convex lens is used as a secondary optical system directly on the surface of the solar cell element has been proposed (see, for example, Patent Document 2). Besides the convex lens, a biconvex lens, a planoconvex lens, or a rhombic lens may be used.

Another structure has been disclosed in which light concentrated by a primary optical system (concentrating lens) is directed into a secondary optical system that is made of a light-transmitting material and that is disposed directly on a solar cell element, where the light is totally reflected by the side faces to concentrate the light on the surface of the solar cell element (see, for example, Patent Documents 3 and 4)
Patent Document 1: JP H11-284217A
Patent Document 2: U.S. Patent No. 5167724
Patent Document 3: JP 2002-289897A
Patent Document 4: JP 2003-258291A

### Disclosure of Invention

### Problems to be Solved by the Invention

The energy obtained by concentrating light at the light-receiving position of the concentrating solar power generation apparatus is very large, so it is necessary to take measures or the like to prevent damage that is caused by the irradiation of the periphery of the solar cell element. However, in the case of the concentrating solar power generation apparatus described in Patent Document 1, the solar cell (solar cell module) structure is complicated and large, making the production process complicated, and it is therefore problematic in terms of reliability, mass productivity, ease of installation, maintenance, etc.

In addition, because concentrating solar power generation apparatuses are often installed in areas where temperature changes are significant, such as a desert, it is also necessary to take measures against heat generated by temperature increase.

That is, in order to achieve a highly reliable solar power generation apparatus (solar cell) that can reliably produce electric power from sunlight, it is very important to provide appropriate measures against heat, concentration of light, environment, and so on when mounting a solar cell element, adjusting the positional relationship between solar cell element and optical system, etc.

In view of the above, it is an object of the present invention to provide a highly reliable solar cell that can be manufactured readily and reliably with a stable manufacturing process and that has high heat resistance, high moisture resistance, and high mass productivity.

It is another object of the present invention to provide a method of manufacturing a solar cell with which it is possible to readily and reliably form a covering portion that protects a solar cell element with good productivity, and to obtain a high yield and high productivity.

It is another object of the present invention to provide a solar cell manufacturing apparatus with which it is possible to readily and rapidly form a resin sealing portion with good productivity, and to manufacture solar cells with good productivity.

Alternatively, it is another object of the present invention to provide a solar cell that has high insulation capabilities and heat dissipation properties with a simple structure, and that achieves high reliability and power generation efficiency.

It is also another object of the present invention to provide a concentrating solar power generation unit that has good heat dissipation properties and good productivity, as well as high power-generation efficiency, with a simple heat dissipation structure.

Furthermore, in the case where a biconvex lens or planoconvex lens is used as a secondary optical system, a problem arises in that the problem of chromatic aberration is aggravated, or the amount of light incident on the solar cell element decreases due to a refractive/transmission loss at the secondary optical system.

According to the method disclosed in Patent Document 2, the entirety of the light incident on the solar cell element passes through the secondary optical system, so a refractive/transmission loss at the secondary optical system occurs, substantially reducing the actual amount of light incident on the solar cell element.

The methods disclosed in Patent Documents 3 and 4 are effective in solving the problems of alignment error, chromatic aberration and light intensity distribution, but these methods require an increased angle of incidence to the side faces of the secondary optical system in order to cause the light to be totally reflected at the side faces. That is, it is necessary to increase the focal distance of the primary optical system and to install the secondary optical system and the solar cell element away from the primary optical system. Consequently, a problem arises in that the thickness of the solar power generation module increases, increasing the total weight.

The weight increase due to the increased thickness of the solar cell module increases the size of a sun-tracking mechanism portion (sun-tracking driving system) that drives the mounted concentrating solar power generation module, causing the sun-tracking concentrating solar power generation apparatus to have disadvantages, such as increased cost, difficulty in handling, and maintenance difficulties.

The methods disclosed in Patent Documents 3 and 4 also have similar problems to those of Patent Document 2, such as a refractive loss at the incident end face and the emitting end face of the secondary optical system, and a reduction in the amount of light incident on the solar cell element due to the transmission loss at the secondary optical system.

Moreover, according to the above-described methods using a secondary optical system, because the secondary optical system directly receives sunlight concentrated by the primary optical system to a high density, the members (material) that constitute the secondary optical system are required to have high heat resistance, increasing the cost of the apparatus as a result.

In particular, in the case of having a high concentration magnification, the energy density of the concentrated light beam increases. Accordingly, if the concentrated sunlight is directed to a region other than the solar cell element due to a sun-tracking error or the like, the members (components such as wiring) other than the solar cell element may burn out, causing a crack in the glass disposed as an optical member. In other words, a sun-tracking concentrating solar power generation apparatus that has sufficient reliability cannot be achieved. Another problem is that measures against heat dissipation that are sufficient to solve the above problems have not yet been proposed.

In view of the above, it is an object of the present invention to provide a solar cell with improved heat resistance and improved weather resistance.

It is another object of the present invention to provide a concentrating solar power generation module with improved heat resistance and improved weather resistance.

It is another object of the present invention to provide a concentrating solar power generation unit with improved heat resistance and improved weather resistance.

It is another object of the present invention to provide a method of manufacturing a solar cell with which it is possible to manufacture a highly reliable solar cell that has superior heat resistance with good productivity.

### Means for solving the Problems

A solar cell according to the present invention includes: a solar cell element that converts sunlight into electricity; a receiver substrate on which the solar cell element is placed; and a covering portion that covers the solar cell element, wherein the covering portion includes: a sealing frame that is formed on a surface of the receiver substrate, has an opening, and surrounds the periphery of the solar cell element; a light-transmitting covering plate that is bonded to the sealing frame and covers the solar cell element; and a resin sealing portion in which a sealing region defined by the sealing frame and the light-transmitting covering plate is filled with sealing resin.

With this configuration, a stable manufacturing process becomes possible, and heat resistance and moisture resistance can be improved significantly. Accordingly, it is possible to obtain a highly reliable solar cell with superior mass productivity.

Also, in the solar cell according to the present invention, the light-transmitting covering plate may be a glass plate.

With this configuration, heat resistance and moisture resistance can be reliably improved.

Also, in the solar cell according to the present invention, the light-transmitting covering plate may have a thickness that can suppress irradiation intensity at a surface of the light-transmitting covering plate to 310 kW/m² or less.

With this configuration, the surface of the light-transmitting covering plate is separated from the surface of the solar cell element, which is heated to a high temperature by the concentrated and directed sunlight, so the irradiation intensity at the surface of the light-transmitting covering plate is reduced, and the surface temperature of the light-transmitting covering plate can be reduced. Therefore, it becomes possible to prevent fire caused by, for example, combustion of extraneous matter at the surface of the light-transmitting covering plate, and to achieve a highly reliable solar cell that has high heat resistance.

Also, in the solar cell according to the present invention, the sealing frame may be formed of a white silicone resin.

With this configuration, a highly reliable sealing frame can be readily formed. Also, the sunlight diffused around the solar cell element is reflected so as to be directed to the solar cell element, and it therefore becomes possible to improve power generation efficiency.

A method of manufacturing a solar cell according to the present invention is a method of manufacturing a solar cell including a solar cell element that converts sunlight into electricity; a receiver substrate on which the solar cell element is placed; and a covering portion that covers the solar cell element, wherein a covering portion forming step of forming the covering portion includes: a sealing frame forming step of forming a sealing frame having an opening on the receiver substrate such that the sealing frame surrounds the periphery of the solar cell element; a covering plate bonding step of bonding a light-transmitting covering plate that covers the solar cell element to the sealing frame; and a resin sealing step of filling a sealing region defined by the sealing frame and the light-transmitting covering plate with sealing resin through the opening to form a resin sealing portion.

With this configuration, a covering portion that protects the solar cell element can be formed readily and reliably with good productivity. Accordingly, it is possible to obtain a solar cell production method with which it is possible to produce solar cells that have high heat resistance and high moisture resistance with high productivity.

Also, in the method of manufacturing a solar cell according to the present invention, the covering plate bonding step may include: a covering plate placing step of placing the light-transmitting covering plate on a covering plate bonding jig; a sealing frame bonding step of placing the receiver substrate on which the sealing frame is formed on the covering plate bonding jig and bonding the light-transmitting covering plate to the sealing frame; and a heat treatment step of heat treating the covering plate bonding jig on which the light-transmitting covering plate and the receiver substrate are placed in a heat treatment furnace.

With this configuration, a sealing frame can be shaped in such a way that the parallelism between the receiver substrate and the light-transmitting covering plate can be defined with high accuracy. Accordingly, a large number of solar-cell sealing frames can be formed with good uniformity and stability, and it is therefore possible to provide a solar cell manufacturing method having a high yield and high productivity.

Also, in the method of manufacturing a solar cell according to the present invention, the covering plate bonding jig may be configured to define a height of the covering portion with a step between a covering plate placing portion on which the light-transmitting covering plate is placed and a receiver substrate placing portion on which the receiver substrate is placed.

With this configuration, the parallelism and spacing (the height of the sealing frame) between the receiver substrate and the light-transmitting covering plate can be established with high accuracy. Accordingly, it becomes possible to form the covering portion with high accuracy and good yield.

Also, in the method of manufacturing a solar cell according to the present invention, the resin sealing step may include: a substrate juxtaposing step of juxtaposing the receiver substrate in a substrate juxtaposition jig with the opening being positioned horizontally in an upper portion of the sealing frame; a resin filling step of filling a sealing region with sealing resin through the opening of the receiver substrate juxtaposed in the substrate juxtaposition jig with a resin injector; and a heat treatment step of heat treating the substrate juxtaposition jig on which the receiver substrate filled with the sealing resin is placed in a heat treatment furnace.

With this configuration, the resin sealing portion can be formed with stability and good productivity, and it is therefore possible to provide a solar cell manufacturing method having a high yield and high productivity.

Also, in the method of manufacturing a solar cell according to the present invention, the substrate juxtaposition jig may be configured such that the receiver substrate is juxtaposed in an inclined state relative to the perpendicular direction.

With this configuration, the sealing resin to be filled can have a flow gradient, enabling smooth resin flow to occur. Accordingly, the sealing resin can be filled into the sealing region in a stable manner.

Also, in the method of manufacturing a solar cell according to the present invention, the resin injector may be disposed such that the resin injector fills with the sealing resin at a position shifted from the center of the opening.

With this configuration, the resin flow can be made smoother, and the incorporation of air bubbles into the sealing resin can be further reduced, making it easy to remove bubbles. Accordingly, a resin sealing portion in which few air bubbles are included can be formed with a good yield.

A solar cell manufacturing apparatus according to the present invention is a solar cell manufacturing apparatus that fills a sealing region defined by a sealing frame surrounding the periphery of a solar cell element placed on a receiver substrate and a light-transmitting covering plate bonded to the sealing frame with sealing resin so as to form a resin sealing portion, the apparatus including: a substrate juxtaposition jig in which a plurality of the receiver substrates to which the light-transmitting covering plate is bonded by the sealing frame are juxtaposed with an opening of the sealing frame being positioned in an upper portion of the sealing frame; and a resin injector that fills the sealing region with sealing resin through the opening.

With this configuration, the resin sealing portion can be formed readily and rapidly with good productivity. Accordingly, it is possible to obtain a solar cell manufacturing apparatus that can manufacture solar cells with good productivity.

Also, in the solar cell manufacturing apparatus according to the present invention, the resin injector may be configured to move in a perpendicular direction, and the substrate juxtaposition jig is configured to move at an equal pitch in a horizontal direction.

With this configuration, the sealing resin can be supplied to a plurality of solar cell elements in a stable manner, and the resin sealing portion can be formed readily with a good yield. Accordingly, it is possible to obtain a highly productive solar cell manufacturing apparatus.

Alternatively, a solar cell according to the present invention is a solar cell including: a solar cell element including a substrate electrode and a surface electrode; and a receiver substrate on which the solar cell element is placed, wherein the receiver substrate includes a base, an intermediate insulating layer laminated on the base, and a connection pattern layer laminated on the intermediate insulating layer, and the substrate electrode and the surface electrode are each connected to the connection pattern layer.

With this configuration, the solar cell element can be readily insulated from the base, and as such, the base can be effectively used as a heat dissipating means having a high heat-dissipating efficiency. Accordingly, it is possible to obtain a solar cell that has high insulation capabilities, heat dissipation properties, superior reliability and good power generation efficiency with a simple structure.

Also, the solar cell according to the present invention may include a surface protection layer that protects the connection pattern layer.

With this configuration, the insulation capabilities of the connection pattern layer can be reliably improved, further improving reliability.

Also, in the solar cell according to the present invention, the receiver substrate and the solar cell element each may have a rectangular shape, and the solar cell element may be disposed such that each side intersects a diagonal line of the receiver substrate.

With this configuration, when the receiver substrate is mounted on the solar cell mounting plate to form a concentrating solar power generation unit, the sides of the solar cell element can be inclined relative to the perpendicular direction, so it is possible to prevent water that has entered from the outside from remaining at a position corresponding to each side of the solar cell element, and a solar cell having improved moisture resistance and improved weather resistance can be obtained.

Also, in the solar cell according to the present invention, the surface electrode may be formed at four corners of the solar cell element, and each may be connected to the connection pattern layer with a wire.

With this configuration, the current generated by the solar cell element can be concentrated at the shortest distance and outputted through each surface electrode, so a solar cell having improved current collecting efficiency can be obtained.

Also, the solar cell according to the present invention may include a radiator that includes a heat dissipating base portion integrated with the base and a heat dissipating projection portion projected from the heat dissipating base portion.

With this configuration, heat resistance can be reduced to improve heat dissipation properties. Accordingly, a solar cell having a high power-generation efficiency can be obtained.

A concentrating solar power generation unit according to the present invention is a concentrating solar power generation unit including: a solar cell including a solar cell element and a receiver substrate on which the solar cell element is placed; and a solar cell mounting plate on which the receiver substrate is mounted, wherein a radiator is disposed on a back face side of the receiver substrate that is opposite to a surface side on which the solar cell element is placed so as to correspond to the solar cell element.

With this configuration, heat generated by the sunlight concentrated and directed to the solar cell element can be dissipated through the receiver substrate and the radiator. Accordingly, it is possible to obtain a concentrating solar power generation unit that has good heat dissipation properties, good productivity and a high power-generation efficiency with a simple heat dissipation structure.

Also, in the concentrating solar power generation unit according to the present invention, the radiator may include: a heat dissipating base portion that contacts the solar cell mounting plate on a back face side of the solar cell mounting plate that is opposite to a surface side on which the receiver substrate is mounted; and a heat dissipating projection portion projected from the heat dissipating base portion.

With this configuration, a heat dissipation path can be formed by the receiver substrate, the solar cell mounting plate, the heat dissipating base portion and the heat dissipating projection portion. Accordingly, it is possible to obtain a concentrating solar power generation unit that has high heat-dissipation properties with a simple heat dissipation structure.

Also, in the concentrating solar power generation unit according to the present invention, the radiator may include a heat dissipating base portion integrated with the receiver substrate and a heat dissipating projection portion projected from the heat dissipating base portion.

With this configuration, because a heat dissipation path can be formed by the receiver substrate, the heat dissipating base portion and the heat dissipating projection portion, the solar cell and the radiator can be readily and reliably mounted on the solar cell mounting plate. In addition, it is possible to obtain a concentrating solar power generation unit that has high heat-dissipation properties with a simple heat dissipation structure.

Also, in the concentrating solar power generation unit according to the present invention, the heat dissipating base portion may be configured such that a thickness of a portion corresponding to the solar cell element is increased relative to a thickness of a portion away from the solar cell element.

With this configuration, heat resistance can be reliably reduced. Accordingly, it is possible to obtain a concentrating solar power generation unit that has even higher heat-dissipation properties.

Also, the solar cell included in the concentrating solar power generation unit according to the present invention may be the solar cell according to the present invention.

With this configuration, because the insulation capabilities and heat dissipation properties can be further improved, it is possible to obtain a highly reliable concentrating solar power generation unit that has good power generation efficiency.

A solar cell according to the present invention is a solar cell including: a solar cell element that converts sunlight concentrated by a concentrating lens into electricity; a receiver substrate on which the solar cell element is placed; a resin sealing portion that seals the solar cell element with resin; and a light-transmitting covering plate that covers a concentrating lens side face of the resin sealing portion, wherein the solar cell includes a reflecting portion that prevents irradiation of the receiver substrate from sunlight on a face facing the resin sealing portion of the light-transmitting covering plate.

With this configuration, even if the concentrated sunlight deviates due to a sun tracking error and is deviated to a position away from the position of the solar cell element, irradiation of the receiver substrate from sunlight can be prevented, suppressing (reducing) temperature increases in the receiver substrate. Accordingly, it is possible to obtain a highly efficient and inexpensive solar cell having improved heat resistance, good reliability and good weather resistance.

Also, in the solar cell according to the present invention, the reflecting portion may be a metallic film.

With this configuration, a reflecting portion having superior reflectivity can be formed readily and inexpensively with good mass productivity.

Also, in the solar cell according to the present invention, the metallic film may be formed using aluminum or silver.

With this configuration, a reflecting portion having superior reflectivity can be formed readily and inexpensively with high accuracy and good mass productivity.

Also, in the solar cell according to the present invention, the reflecting portion may be a metallic plate.

With this configuration, a reflecting portion having superior reflectivity can be formed readily and inexpensively with simple steps.

Also, in the solar cell according to the present invention, the metallic plate is an aluminum plate or a stainless steel plate.

With this configuration, the reflecting portion can be formed readily and inexpensively with simple steps.

Also, in the solar cell according to the present invention, the reflecting portion has a reflection coefficient at a wavelength of 400 nm to 1200 nm measured at a surface of the light-transmitting covering plate of 60% or more.

With this configuration, reflection can be reliably caused.

A concentrating solar power generation module according to the present invention is a concentrating solar power generation module including: a concentrating lens that concentrates sunlight; and a solar cell that converts sunlight concentrated by the concentrating lens into electricity, wherein the solar cell is the solar cell according to the present invention.

With this configuration, it is possible to obtain a highly reliable concentrating solar power generation module having improved heat resistance.

Also, a concentrating solar power generation unit according to the present invention is a concentrating solar power generation unit including: an elongated frame; and a plurality of concentrating solar power generation modules arranged along the elongated frame, wherein the concentrating solar power generation module is the concentrating solar power generation module according to the present invention.

With this configuration, it is possible to obtain a highly reliable concentrating solar power generation unit having improved heat resistance.

A method of manufacturing a solar cell according to the present invention is a method of manufacturing a solar cell including: a solar cell element that converts sunlight concentrated by a concentrating lens into electricity; a receiver substrate on which the solar cell element is placed; a resin sealing portion that seals the solar cell element with resin; a light-transmitting covering plate that covers the resin sealing portion; and a reflecting portion that is formed on a face facing the resin sealing portion of the light-transmitting covering plate and that prevents irradiation of the receiver substrate from sunlight, the method including: a light-transmitting covering plate preparation step of preparing the light-transmitting covering plate; a metallic film forming step of forming a metallic film on a face facing the resin sealing portion of the light-transmitting covering plate; a metallic film heat treatment step of heat treating the metallic film to form the reflecting portion that prevents irradiation of the receiver substrate from sunlight; and a resin sealing step of forming the resin sealing portion in a state in which the light-transmitting covering plate in which the reflecting portion is formed is disposed facing the solar cell element.

With this configuration, a reflecting portion can be formed readily with high accuracy, so it is possible to manufacture a highly reliable solar cell that has superior heat resistance with good productivity.

A method of manufacturing a solar cell according to the present invention is a method of manufacturing a solar cell including: a solar cell element that converts sunlight concentrated by a concentrating lens into electricity, a receiver substrate on which the solar cell element is placed, a resin sealing portion that seals the solar cell element with resin, a light-transmitting covering plate that covers the resin sealing portion, and a reflecting portion that is formed on a face facing the resin sealing portion of the light-transmitting covering plate and that prevents irradiation of the receiver substrate from sunlight, the method including: a light-transmitting covering plate preparation step of preparing the light-transmitting covering plate; a metallic plate preparation step of preparing a metallic plate having a shape of the reflecting portion; a metallic plate bonding step of bonding the metallic plate to the light-transmitting covering plate to form the reflecting portion; and a resin sealing step of forming the resin sealing portion in a state in which the light-transmitting covering plate in which the reflecting portion is formed is disposed facing the solar cell element.

With this configuration, the process can be simplified, and a reflecting portion can be formed readily with high accuracy, so it is possible to manufacture a highly reliable solar cell that has superior heat resistance with good productivity at a low cost.

### Effects of the Invention

In the solar cell of the present invention, because a covering portion that covers a solar cell element placed on a receiver substrate is configured from a sealing frame that surrounds the periphery of the solar cell element, a light-transmitting covering plate that is bonded to the sealing frame and that covers the solar cell element, and a resin sealing portion that is formed in a sealing region defined by the sealing frame and the light-transmitting covering plate, the solar cells can be manufactured readily and reliably with a stable manufacturing process, and the effects of obtaining high heat resistance and high moisture resistance and improving mass productivity and reliability can be achieved. In addition, it is possible to achieve the significant effects of providing a concentrating solar cell, in which sunlight having a high energy density is directed by a concentrating lens, at a lower cost.

According to the method of manufacturing a solar cell of the present invention, a covering portion forming step of forming a covering portion that covers a solar cell element placed on a receiver substrate involves a sealing frame forming step of forming a sealing frame that surrounds the periphery of the solar cell element, a covering plate bonding step of bonding a light-transmitting covering plate covering the solar cell element to the sealing frame, and a resin sealing step of filling a sealing region with sealing resin to form a resin sealing portion. Accordingly, the covering portion that protects the solar cell element can be formed readily and reliably with good productivity, and the effects of a high yield and high productivity can be achieved.

According to the solar cell manufacturing apparatus of the present invention, a solar cell manufacturing apparatus that fills a sealing region defined by a sealing frame surrounding the periphery of a solar cell element placed on a receiver substrate and a light-transmitting covering plate bonded to the sealing frame with sealing resin so as to form a resin sealing portion is configured from a substrate juxtaposition jig in which a plurality of receiver substrates are juxtaposed with an opening of the sealing frame being positioned in an upper portion of the sealing frame and a resin injector that fills the sealing region with sealing resin through the opening. Accordingly, the resin sealing portion can be formed readily and rapidly with good productivity, and the effect of manufacturing a solar cell with good productivity can be achieved.

Alternatively, according to the solar cell of the present invention, a solar cell element is placed on a receiver substrate including a base, an intermediate insulating layer laminated on the base and a connection pattern layer laminated on the intermediate insulating layer, and an external connecting terminal of the solar cell element is drawn from the connection pattern layer. Accordingly, the base can be utilized effectively as a heat dissipating means by insulating the solar cell element from the base, so the effects of high insulation capabilities, heat dissipation properties, high reliability and high power-generation efficiency can be achieved with a simple structure.

In other words, the solar cell according to the present invention has high insulation capabilities and heat dissipation properties with a simple structure, so a significant effect is obtained by applying it as a solar cell in which a concentrating solar cell element, to which concentrated sunlight is directed, is placed.

Furthermore, according to the concentrating solar power generation unit of the present invention, a receiver substrate on which a solar cell element is placed is fixed to a solar cell mounting plate, and a radiator is disposed on the back face side of the receiver substrate that is opposite to the surface side on which the solar cell element is placed so as to correspond to the solar cell element. Accordingly, the heat generated by the sunlight concentrated and directed to the solar cell element can be dissipated through the receiver substrate and the radiator, so the effect of heat dissipation properties, good productivity and high power-generation efficiency with a simple heat dissipation structure can be obtained.

Alternatively, according to the solar cell of the present invention, a reflecting portion that prevents irradiation of the receiver substrate from sunlight is provided on a face of the light-transmitting covering plate, facing the resin sealing portion. Accordingly, deviated sunlight can be reflected, and an effect of improving heat resistance to improve reliability and weather resistance can be produced.

Furthermore, the concentrating solar power generation module of the present invention includes a solar cell in which a reflecting portion that reflects deviated sunlight is provided. Accordingly, deviated sunlight can be reflected, so the effect of improving heat resistance to improve reliability and weather resistance can be produced.

In addition, the concentrating solar power generation unit of the present invention includes a plurality of concentrating solar power generation modules, and a solar cell in which a reflecting portion that reflects deviated sunlight is provided is included in the concentrating solar power generation modules. Accordingly, deviated sunlight can be reflected, so the effect of improving heat resistance to improve reliability and weather resistance can be produced.

Also, according to the solar cell manufacturing method of the present invention, the reflecting portion that reflects deviated sunlight is formed using a metallic film, so the reflecting portion can be formed readily with high accuracy, and the effect of manufacturing a highly reliable solar cell with superior heat resistance with good productivity can be produced.

Also, according to the solar cell manufacturing method of the present invention, the reflecting portion that reflects deviated sunlight is formed using a metallic plate, so the process can be simplified, the reflecting portion can be formed readily with high accuracy, and the effect of manufacturing a highly reliable solar cell that has superior heat resistance with good productivity can be produced.

### Brief Description of Drawings

[FIG. 1] FIG. 1 is an explanatory diagram illustrating an overall configuration of a solar cell according to Embodiment 1 of the present invention, with FIG. 1(A) being a plan view of the solar cell in which a solar cell element is placed on a receiver substrate, and FIG. 1(B) being a cross-sectional view of the cross section taken along the line B-B of FIG. 1(A).
[FIG. 2] FIG. 2 is a process explanatory diagram illustrating a process of a method of manufacturing a solar cell according to Embodiment 2 of the present invention, with FIG. 2(A) being a plan view showing a solar cell element placed on a receiver substrate, and FIG. 2(B) being a cross-sectional view showing the cross section taken along the line B-B of FIG. 2(A).
[FIG. 3] FIG. 3 is a process explanatory diagram illustrating a process of the method of manufacturing a solar cell according to Embodiment 2 of the present invention, with FIG. 3(A) being a plan view showing a state in which a sealing frame is formed on the surface of a receiver substrate, and FIG. 3(B) being a cross-sectional view showing the cross section taken along the line B-B of FIG. 3(A).
[FIG. 4] FIG. 4 is a process explanatory diagram illustrating a process of the method of manufacturing a solar cell according to Embodiment 2 of the present invention, with FIG. 4(A) being a plan view showing a state in which a light-transmitting covering plate is bonded to a sealing frame, and FIG. 4(B) being a cross-sectional view showing the cross section taken along the line B-B of FIG. 4(A).
[FIG. 5] FIG. 5 is a process explanatory diagram illustrating a process of the method of manufacturing a solar cell according to Embodiment 2 of the present invention, with FIG. 5(A) being a plan view showing a state in which a resin sealing portion is formed by filling sealing resin from an opening, and FIG. 5(B) being a cross-sectional view showing the cross section taken along the line B-B of FIG. 5(A).

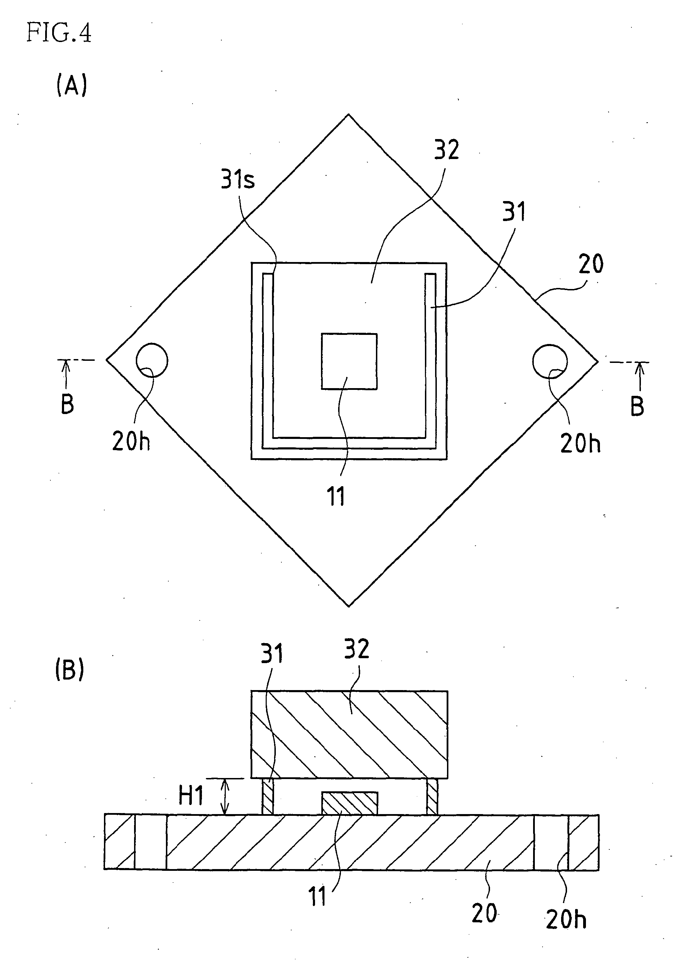

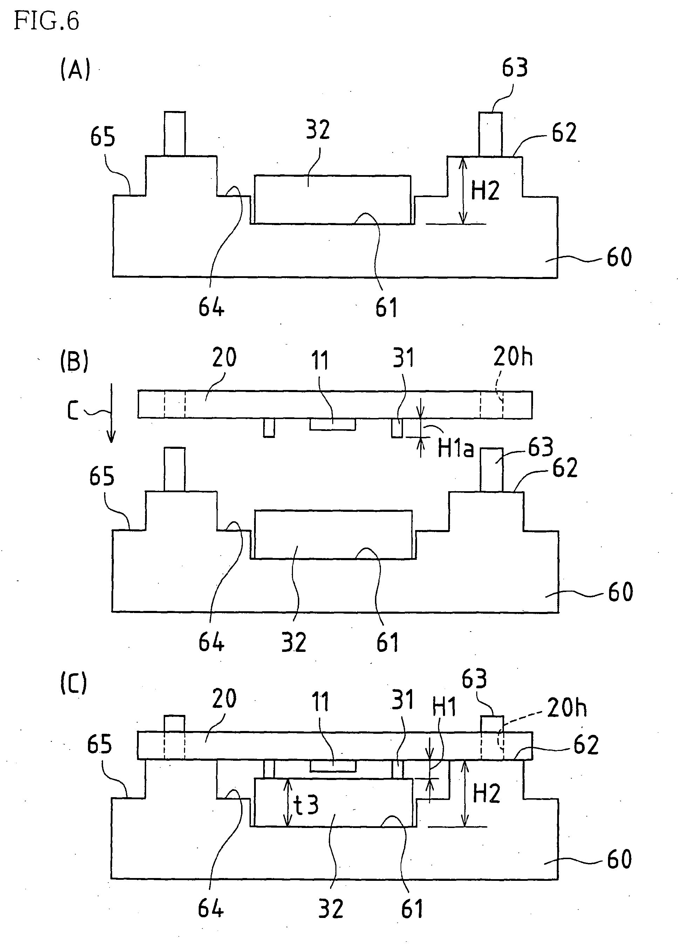

[FIG. 6] FIG. 6 is a process diagram illustrating a covering plate bonding step shown in FIG. 4 in further detail, with FIG. 6(A) being a schematic side view conceptually showing a state in which a light-transmitting covering plate is placed on a covering plate bonding jig, FIG. 6(B) being a schematic side view conceptually showing a state in which a receiver substrate in which a sealing frame is formed is positioned on a light-transmitting covering plate, and FIG. 6(C) being a schematic side view conceptually showing a state in which a light-transmitting covering plate and a sealing frame are bonded.
[FIG. 7] FIG. 7 is plan view showing an example of the covering plate bonding jig shown in FIG. 6.
[FIG. 8] FIG. 8 is a plan view showing a state in which receiver substrates are placed on the covering plate bonding jig shown in FIG. 7.
[FIG. 9] FIG. 9 is a process explanatory diagram illustrating the resin sealing step shown in FIG. 5 in further detail, and is a schematic side view conceptually showing a state in which a plurality of receiver substrates are arranged side by side in a substrate juxtaposition jig and sealing resin is filled using a resin injector.
[FIG. 10] FIG. 10 is a schematic front view showing a state as viewed from the direction of the arrow S of FIG. 9.
[FIG. 11] FIG. 11 is an explanatory diagram illustrating an example of the substrate juxtaposition jig shown in FIG. 9, with FIG. 11(A) being a front view illustrating a state, taken in the same direction as FIG. 9, FIG. 11(B) being a side view as viewed from the direction of the arrow B of FIG. 11(A), and FIG. 11(C) being a plan view as viewed from the direction of the arrow C of FIG. 11(A).
[FIG. 12] FIG. 12 is an explanatory diagram illustrating a horizontal movement mechanism with which the substrate juxtaposition jig of the solar cell manufacturing apparatus shown in FIG. 9 moves horizontally at an equal pitch, with FIG. 12(A) being a plan view of the horizontal movement mechanism showing a state before horizontal movement is performed, and FIG. 12(B) being a plan view of the horizontal movement mechanism showing a state after horizontal movement is performed by a distance equal to four receiver substrates.
[FIG. 13] FIG. 13 is an explanatory diagram illustrating a solar cell according to Embodiment 3 of the present invention, with FIG. 13(A) being a plan view, and FIG. 13(B) being a cross-sectional view of the cross section taken along the line B-B of FIG. 13(A).
[FIG. 14] FIG. 14 is an enlarged plan view showing a state of a surface electrode of the solar cell element shown in FIGS. 13(A) and 13(B).
[FIG. 15] FIG. 15 is an exploded perspective view showing an overall configuration of a concentrating solar power generation unit according to Embodiment 4 of the present invention.
[FIG. 16] FIG. 16 is a plan view showing a solar cell arrangement in which the concentrating solar power generation unit shown in FIG. 15 is mounted on a solar cell mounting plate.
[FIG. 17] FIG. 17 is a cross-sectional view of a radiator according to Example 1 that is applied to the concentrating solar power generation unit according to Embodiment 4 of the present invention, which shows a state of the cross section taken along the line A-A of FIG. 16.
[FIG. 18] FIG. 18 is an explanatory diagram illustrating the radiator shown in FIG. 17, with FIG. 18(A) being a plan view showing a state of the tips of the heat dissipating projection portions and FIG. 18(B) being a front view showing a projecting state of the heat dissipating projection portions.
[FIG. 19] FIG. 19 is a cross-sectional view of a radiator according to Example 2 that is applied to the concentrating solar power generation unit according to Embodiment 4 of the present invention, which shows a state of the cross section taken along the line A-A of FIG. 16.
[FIG. 20] FIG. 20 is a cross-sectional view showing a configuration of a solar cell and a concentrating solar power generation module according to Embodiment 5 of the present invention.
[FIG. 21] FIG. 21 is an explanatory diagram illustrating a configuration of a solar cell according to Embodiment 6 of the present invention, with FIG. 21(A) being a plan view as viewed from the concentrating lens side, and FIG. 21(B) being a cross-sectional view taken along the line B-B of FIG. 21(A).
[FIG. 22] FIG. 22 is an explanatory diagram showing a configuration of a solar cell according to a variation of Embodiment 6 of the present invention, with (A) being a plan view as viewed from the concentrating lens side, and FIG. 22(B) being a cross-sectional view taken along the line B-B of FIG. 22(A).
[FIG. 23] FIG. 23 is a cross-sectional view showing a configuration of a solar cell according to Embodiment 7 of the present invention.
[FIG. 24] FIG. 24 is a perspective view schematically illustrating a configuration of a concentrating solar power generation unit according to Embodiment 8 of the present invention.
[FIG. 25] FIG. 25 is a cross-sectional view showing the configuration of a concentrating solar power generation module that is applied to a conventional sun-tracking concentrating solar power generation apparatus.

### Description of Reference Numerals

- 10, 10A, 10B, 10C, 10D, 10E: Solar Cell
- 11: Solar Cell Element
- 14: Surface Electrode
- 17, 18: Wire
- 20: Receiver Substrate
- 21: Base
- 22: Intermediate Insulating Layer
- 23: Connection Pattern Layer
- 23s: Surface Electrode Connection Pattern
- 23b: Substrate Electrode Connection Pattern
- 23d,: 23sc Surface Electrode Connection Portion
- 23bc: Substrate Electrode Connection Portion
- 24: Surface Electrode Output Terminal
- 25: Substrate Electrode Output Terminal
- 27: Surface Protection Layer
- 30, 30B, 30C, 30D, 30E: Covering Portion
- 31: Sealing Frame
- 31s: Opening
- 32: Light-Transmitting Covering Plate
- 33, 33B, 33C, 33D, 33E: Resin Sealing Portion
- 35: Reflecting Portion
- 35w: Light-Transmitting Window
- 36: Bonding Portion
- 40, 40a: Concentrating Solar Power Generation Unit
- 40m: Concentrating Solar Power Generation Module
- 41: Light-Transmitting Protection Plate
- 42: Concentrating Lens
- 44: Elongated Frame
- 47: Solar Cell Mounting Plate
- 50, 53: Radiator
- 51, 54: Heat Dissipating Base Portion
- 52, 55: Heat Dissipating Projection Portion
- 60: Covering Plate Bonding Jig
- 61: Covering Plate Placing Portion
- 62: Receiver Substrate Placing Portion
- 63: Positioning Protrusion Portion
- 64: Inner Step Portion
- 65: Outer Step Portion
- 70: Solar Cell Manufacturing Apparatus
- 71: Substrate Juxtaposition Jig
- 71b: Juxtaposition Base Plate
- 71bg: Substrate Placing Groove
- 71s: Juxtaposition Side Plate
- 71sg: Substrate Engaging Groove
- 72: Resin Injector
- 73: Work Stage
- 74: Equal Pitch Scale
- 74c: Comb-Like Protrusion Portion
- 75: Moving Scale
- 75c: Comb-Like Protrusion Portion
- Dpc: Arrangement Spacing (Equal Pitch)
- Dpg: Arrangement Spacing (Equal Pitch)
- H1, H2: Height
- Mpp: Horizontal Direction
- Mij: Vertical Direction
- t3: Thickness
- α: Angle Of Inclination
- θ: Flow Gradient
- ST1: Unit Stroke
- ST4: Stroke Four Times ST1
- FP: Focal Position
- LRR: Optical Path Range
- Ls: Sunlight
- Lsb: Sunlight
- Lss: Sunlight
- Lsv: Sunlight
- Rot h: Horizontal Rotation
- Rot v: Perpendicular Rotation

### Best Mode for Carrying Out the Invention

Hereinafter, embodiments of the present invention will be described with reference to the accompanying drawings.

### <Embodiment 1>

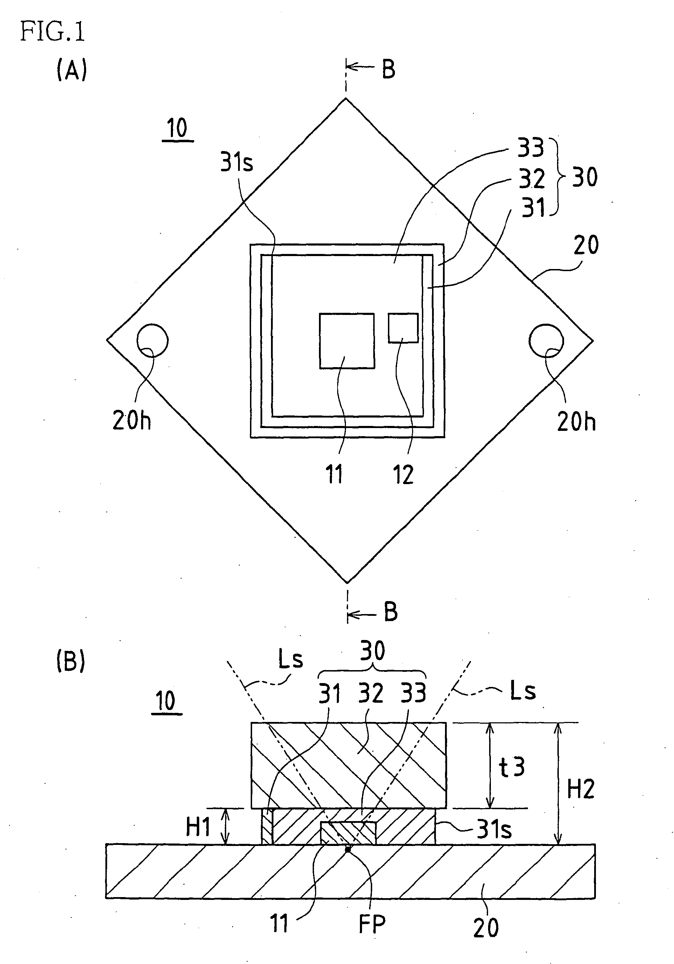

FIG. 1 is an explanatory diagram illustrating an overall configuration of a solar cell according to Embodiment 1 of the present invention, with FIG. 1(A) being a plan view of the solar cell in which a solar cell element is placed on a receiver substrate, and FIG. 1(B) being a cross-sectional view of the cross section taken along the line B-B of FIG. 1(A).

A solar cell 10 according to Embodiment 1 includes a concentrating solar cell element 11 that generates power by converting directed sunlight Ls concentrated by a concentrating lens (not shown) into electricity, and a receiver substrate 20 on which the solar cell element 11 is placed. The solar cell element 11 is disposed on a center portion of the receiver substrate 20 in consideration of the uniform dissipation of heat.

A bypass diode 12 is connected to the solar cell element 11 in parallel. The bypass diode 12 secures a current path in the case where the solar cell element 11 acts as a resistor when sunlight Ls is blocked or the like, and is configured such that, even if a particular solar cell element 11 fails to perform its power generation function when, for example, a concentrating solar power generation unit (not shown) is constituted by connecting a plurality of solar cell elements 11, the power generation function as a whole can be maintained.

The solar cell element 11 is an approximately 5 to 10 mm-square chip obtained from a wafer by forming a PN junction, electrodes, and so on, by known semiconductor manufacture processes using, for example, a GaAs-based compound semiconductor. The solar cell element 11 includes, as electrodes, a substrate electrode disposed on the substrate side of the chip and a surface electrode disposed on the surface side of the chip (in order to facilitate understanding of a covering portion 30, the substrate electrode and the surface electrode are not shown).

The receiver substrate 20 includes, for example, a base, an intermediate insulating layer laminated on the base, a connection pattern layer laminated on the intermediate insulating layer, and a surface protection layer that protects the connection pattern layer (in order to facilitate understanding of the covering portion 30, the base, the intermediate insulating layer, the connection pattern layer and the surface protection layer are not shown). The base is made of, for example, aluminum so as to improve heat dissipation properties and to reduce weight.

The solar cell element 11 and the bypass diode 12 are connected to the connection pattern layer via an appropriate wire (not shown).

The receiver substrate 20 is, for example, a 40 to 80 mm square relative to, for example, an approximately 8 to 10 mm solar cell element 11. The thickness of the receiver substrate 20 is, for example, approximately 1 to 4 mm in consideration of the achievement of heat dissipation properties and weight reduction. A pair of mount connection holes 20h for mounting and fixing the solar cell 10 onto a solar cell mounting plate (not shown) are formed diagonally to each other on the receiver substrate 20.

A covering portion 30 with an appropriate size to protect the solar cell element 11 and the bypass diode 12 from the external environment is formed in a center portion of the receiver substrate 20 so as to cover the solar cell element 11 and the bypass diode 12.

The solar cell element 11 and the receiver substrate 20 each have a rectangular shape, and the solar cell element 11 is disposed such that each side intersects a diagonal line of the receiver substrate 20. The covering portion 30 is formed so as to have a shape (rectangular shape) that corresponds to the rectangular shape of the solar cell element 11. Such a rectangular shape is preferably a square considering the shape of a concentrating lens (not shown), and it is preferable that each side and each diagonal axis intersect perpendicular to each other, but the configuration is not limited to this.

The covering portion 30 includes a sealing frame 31 that has an opening 31s and that is formed on the surface of the receiver substrate 20 so as to surround the far periphery of the solar cell element 11, a light-transmitting covering plate 32 that is bonded to the sealing frame 31 so as to cover the solar cell element 11, and a resin sealing portion 33 whose sealing region defined by the sealing frame 31 and the light-transmitting covering plate 32 is filled with sealing resin.

The sealing frame 31 is configured such that its outer perimeter is nearly equal to or slightly smaller than the outer perimeter of the light-transmitting covering plate 32 in order to prevent its outer perimeter from extending beyond the receiver substrate 20. The inner perimeter of the sealing frame 31 is preferably disposed at a position slightly apart from the solar cell element 11 and the bypass diode 12 so that the solar cell element 11 and the bypass diode 12 are resin-sealed with the resin sealing portion 33.

The sealing frame 31 as a whole is formed in a U-shaped (as viewed from above) wall shape with an opening 31s. As a result of this, a configuration is obtained in which the opening 31s is a wide opening, and this makes the injection of sealing resin that constitutes a resin sealing portion 33 through the opening 31s very easy. Also, it becomes possible to form a resin sealing portion 33 that has an area (coverage area) sufficient to protect the solar cell element 11 and the bypass diode 12.

In order to avoid the mechanical influence of the light-transmitting covering plate 32 on the solar cell element 11 and the bypass diode 12 (as well as wires bonded to the respective surfaces of the solar cell element 11 and the bypass diode 12), the sealing frame 31 is formed so as to have a height H1 (which is higher than the height of the wires bonded to the surfaces of the solar cell element 11 and the solar cell element 11, and is, for example, approximately 1 to 2 mm) that does not allow the light-transmitting covering plate 32 to make contact with the surfaces of the solar cell element 11 and the bypass diode 12 (as well as wires bonded to the surfaces).

The sealing frame 31 is preferably formed of a white silicone resin. Using a white silicone resin allows a highly reliable sealing frame 31 to be readily formed, and the sunlight Ls diffused around the solar cell element 11 can be reflected and directed to the solar cell element 11, so that the power generation efficiency can be further improved. It also makes it possible to prevent the temperature of the sealing frame 31 itself from increasing.

It is preferable that the light-transmitting covering plate 32 is a glass plate. Using a glass plate reliably improves heat resistance and moisture resistance, improving weather resistance. The light-transmitting covering plate 32 is, for example, 20 to 30 mm square, and is bonded to the sealing frame 31 (U-shaped portion).

It is preferable that the light-transmitting covering plate 32 has a thickness t3 that suppresses irradiation intensity at the surface (the side in which sunlight Ls enters) of the light-transmitting covering plate 32 to 310 kW/m² or less.

The surface of the solar cell element 11 (and the adjacent periphery) is heated to a very high temperature through the influence of the energy density of the sunlight Ls because it is disposed so as to nearly correspond to the focal position FP of the sunlight Ls concentrated by a concentrating lens and directed. However, by thickening the light-transmitting covering plate 32 (to have a thickness t3) so as to separate the surface of the light-transmitting covering plate 32 (the opposite side to the solar cell element 11) from the focal position FP that is set to correspond to the surface of the solar cell element 11 by an appropriate distance, the energy density of the sunlight Ls at the surface of the light-transmitting covering plate 32 decreases, so it becomes possible to suppress the surface temperature of the light-transmitting covering plate 32.

In other words, because the surface of the solar cell element 11, which is heated to a high temperature by the action of the concentrated sunlight Ls, is separated from the surface of the light-transmitting covering plate 32 so as to reduce the irradiation intensity at the surface of the light-transmitting covering plate 32 to decrease the surface temperature of the light-transmitting covering plate 32, it becomes possible to prevent a fire or the like caused by the combustion of extraneous matter (for example, matter that has entered from the outside and reached the surface of the light-transmitting covering plate 32) at the surface of the light-transmitting covering plate 32, so a highly reliable solar cell having high heat resistance can be obtained.

The resin sealing portion 33 can be formed using, for example, a transparent silicone resin. Because the solar cell element 11 is sealed with a highly transparent silicone resin, it is possible to obtain a covering portion 30 with superior moisture resistance, superior heat resistance, superior weather resistance, and little loss of sunlight Ls.

In Embodiment 1, when the focal distance (the spacing between the position of the concentrating lens and the solar cell element 11 (focal position FP)) is set to, for example, approximately 360 mm, by setting the thickness t3 to, for example, approximately 4 to 10 mm, an effect that suppresses surface temperature is sufficiently obtained. The lower limit of the thickness t3 is determined by what upper limit for the surface temperature of the light-transmitting covering plate 32 is allowed, and the upper limit of the thickness t3 can be determined based on the productivity of the light-transmitting covering plate 32, such as processability.

Considering processability, production cost and the like of the light-transmitting covering plate 32, it is preferable that the thickness t3 is relatively small, as small as, for example, approximately 4 to 8 mm. When the light-transmitting covering plate 32 is thickened to have an appropriate thickness, for example, a thickness of 5 to 6 mm, heat resistance can be improved. Accordingly, even if a fire caused by combustion of extraneous matter occurs at the surface of the light-transmitting covering plate 32, no damage occurs in the light-transmitting covering plate 32, and high reliability can therefore be secured.

With the above-described configuration, the height H2 of the covering portion 30 is defined by the sum of the height H1 of the sealing frame 31 and the thickness t3 of the light-transmitting covering plate 32.

In the solar cell 10 according to Embodiment 1, because the covering portion 30 is configured as described above, heat resistance and moisture resistance can be improved significantly to improve weather resistance, and a stable manufacturing process becomes possible. Accordingly a highly reliable solar cell with superior mass productivity can be obtained.

### <Embodiment 2>

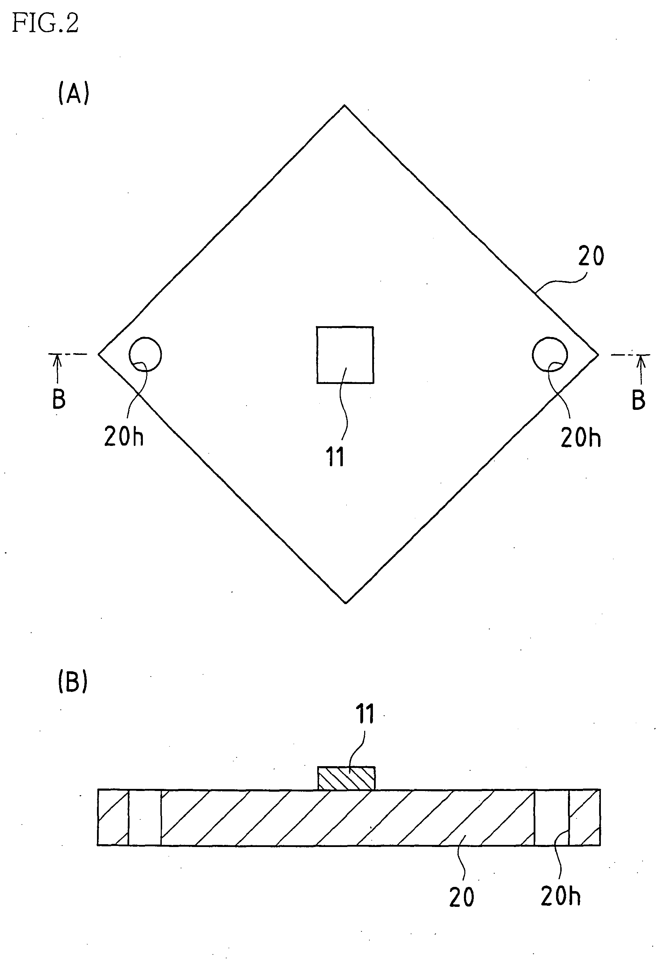

A method of manufacturing the solar cell according to Embodiment 1 of the present invention will be described as Embodiment 2 (a solar cell manufacturing method) of the present invention with reference to FIGS. 2 to 12.

FIG. 2 is a process explanatory diagram illustrating a process of the method of manufacturing a solar cell according to Embodiment 2 of the present invention. FIG. 2(A) is a plan view showing a solar cell element placed on a receiver substrate, and FIG. 2(B) is a cross-sectional view showing the cross section taken along the line B-B of FIG. 2(A).

A solar cell element 11 is attached to a center portion (connection pattern layer) of a receiver substrate 20 by soldering. So as to simplify the drawings, a bypass diode 12 is not shown, but the bypass diode 12 is also attached to the receiver substrate 20 by soldering, as in the case of the solar cell element 11. As in Embodiment 1, the surface electrode of the solar cell element 11, the connection pattern layer of the receiver substrate 20, wires and the like are not shown.

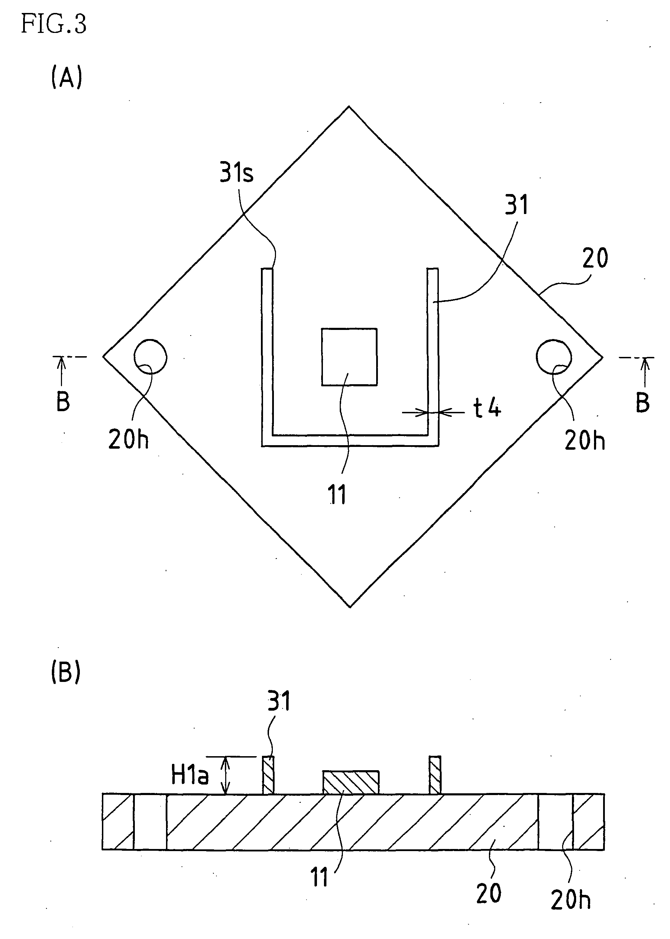

FIG. 3 is a process explanatory diagram illustrating a process of the method of manufacturing a solar cell according to Embodiment 2 of the present invention. FIG. 3(A) is a plan view showing a state in which a sealing frame is formed on the surface of a receiver substrate, and FIG. 3(B) is a cross-sectional view showing the cross section taken along the line B-B of FIG. 3(A).

A sealing frame 31 having an opening 31s is formed on the surface of the receiver substrate 20 on which the solar cell element 11 is placed so as to have a U-shaped (as viewed above) wall shape that surrounds the periphery of the solar cell element 11 (sealing frame forming step). The height H1a of the sealing frame 31 is set to be slightly greater than the height H1 (see FIGS. 1 and 4) because the sealing frame 31 is pressed by a light-transmitting covering plate 32 in the subsequent covering plate bonding step.

The sealing frame 31 can be formed by applying a white silicone resin onto the surface of the receiver substrate 20 using an extruder (not shown) capable of moving as appropriate relative to the plane coordinates. The sealing frame 31 is formed so as to have a rectangular shape that corresponds to the shape of the solar cell element 11, but one of the four sides of the rectangular shape is left open by not extruding (applying) the silicone resin so as to obtain a shape having an opening 31s.

By using a silicone resin (adhesive) as the sealing frame 31, the sealing frame 31 can be formed stably with very good control. It is also possible to readily secure adhesion between the receiver substrate 20 and the sealing frame 31, so a highly reliable sealing frame 31 (covering portion 30) can be formed.

The thickness t4 of the wall shape portion of the sealing frame 31 can be a thickness that can secure enough strength to bond and fix the light-transmitting covering plate 32, and it can be adjusted as appropriate.

FIG. 4 is a process explanatory diagram illustrating a process of the method of manufacturing a solar cell according to Embodiment 2 of the present invention. FIG. 4(A) is a plan view showing a state in which a light-transmitting covering plate is bonded to the sealing frame. FIG. 4(B) is a cross-sectional view showing the cross section taken along the line B-B of FIG. 4(A).

A light-transmitting covering plate 32 (glass plate) that covers the solar cell element 11 is overlaid (positioned) on the sealing frame 31 and then bonded (covering plate bonding step). By pressing the light-transmitting covering plate 32 against the sealing frame 31 by appropriately applying pressure, the light-transmitting covering plate 32 can be bonded to the sealing frame 31. The height H1a of the sealing frame 31 (see FIG. 3) is adjusted to a predetermined height H1 by being pressed by the light-transmitting covering plate 32 in the covering plate bonding step.

Because a silicone resin (adhesive) is used as the sealing frame 31, adhesion between the sealing frame 31 and the light-transmitting covering plate 32 can be readily achieved. Also, by subjecting the sealing frame 31 bonded to the light-transmitting covering plate 32 to a heat treatment, for example, at 150°C for 30 minutes, the sealing frame 31 can be readily cured. Accordingly, a highly reliable covering portion 30 can be readily formed with good workability.

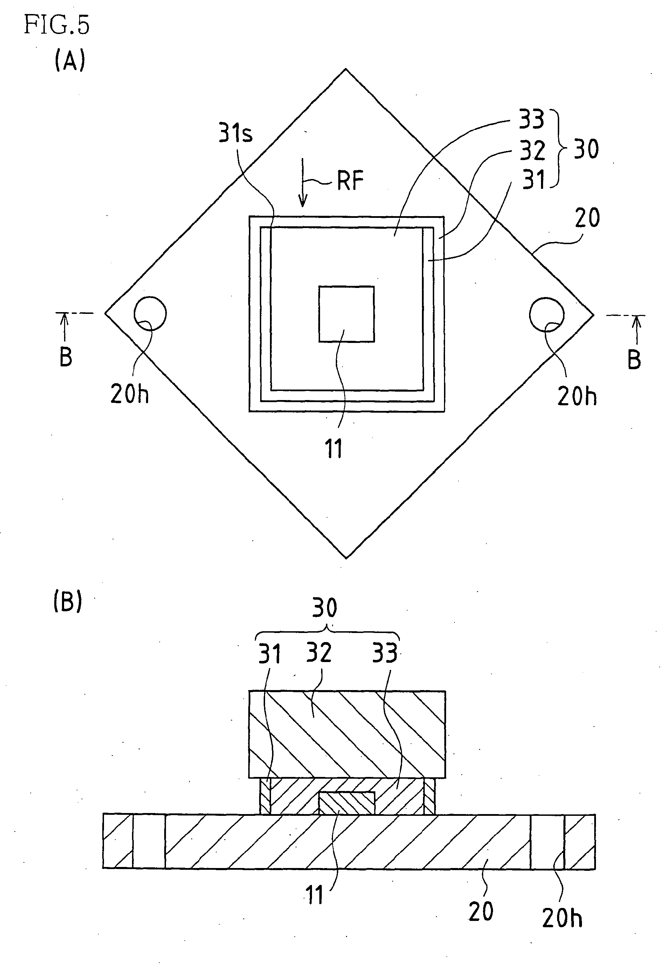

FIG. 5 is a process explanatory diagram illustrating a process of the method of manufacturing a solar cell according to Embodiment 2 of the present invention. FIG. 5(A) is a plan view showing a state in which a resin sealing portion is formed by filling sealing resin through an opening. FIG. 5(B) is a cross-sectional view showing the cross section taken along the line B-B of FIG. 5(A).

Sealing resin (silicone resin having high light transmitting capability) is filled through the opening 31s in the direction of the arrow RF to form a resin sealing portion 33 (resin sealing step). Because the sealing frame 31 is formed so as to have a U shape, filling with sealing resin can be readily performed through a wide opening (opening 31s).

In addition, the wide opening 31s allows the position at which the sealing resin is injected to be shifted as appropriate from the center of the opening 31s (the center of the opening) when filling the sealing resin, so it is possible to make smooth resin flow and to prevent the incorporation of air bubbles.

After filling with the sealing resin, a heat treatment is performed, for example, at 150°C for 30 minutes to cure the sealing resin, forming a resin sealing portion 33 (resin sealing step). Accordingly, a highly reliable resin sealing portion 33 can be readily formed with good workability.

As described above, FIGS. 3 to 5 illustrate a covering portion forming step of forming a covering portion 30 (a sealing frame forming step of forming a sealing frame 31, a covering plate bonding step of bonding a light-transmitting covering plate 32 to the sealing frame 31, and a resin sealing step of forming a resin sealing portion 33 in a sealing region defined by the sealing frame 31 and the light-transmitting covering plate 32). With the covering portion forming step which is stable, a covering portion 30 can be formed readily and reliably with good productivity, so a solar cell manufacturing method with high yield and productivity will be obtained.

FIG. 6 is a process explanatory diagram illustrating the covering plate bonding step shown in FIG. 4 in further detail. FIG. 6(A) is a schematic side view conceptually showing a state in which the light-transmitting covering plate is placed on a covering plate bonding jig. FIG. 6(B) is a schematic side view conceptually showing a state in which the receiver substrate having the sealing frame formed thereon is positioned on the light-transmitting covering plate. FIG. 6(C) is a schematic side view conceptually showing a state in which the light-transmitting covering plate and the sealing frame are bonded.

The covering plate bonding step of Embodiment 2 involves a covering plate placing step of placing a light-transmitting covering plate 32 on a covering plate bonding jig 60 (FIG. 6(A)), a sealing frame bonding step of positioning a receiver substrate 20 having a sealing frame 31 formed thereon on the covering plate bonding jig 60 (light-transmitting covering plate 32) (FIG. 6(B)) so as to place the receiver substrate 20 on the covering plate bonding jig 60 and bonding the light-transmitting covering plate 32 to the sealing frame 31 (FIG. 6(C)), and a heat treatment step of heat treating the covering plate bonding jig 60 on which the light-transmitting covering plate 32 and the receiver substrate 20 are placed in a heat treatment furnace (not shown) so as to cure the sealing frame 31.

In the covering plate placing step (FIG. 6(A)), a light-transmitting covering plate 32 is placed on a covering plate placing portion 61 that is formed into a recess in the center portion of a covering plate bonding jig 60. A receiver substrate placing portion 62 is formed around the covering plate placing portion 61.

A positioning protrusion portion 63 is formed into a pin shape in the receiver substrate placing portion 62 so that a receiver substrate 20 can be positioned to the light-transmitting covering plate 32 with high accuracy. That is, a positioning protrusion portion 63 is formed in an appropriate position such that a mount connection hole 20h of a receiver substrate 20 is fitted to the positioning protrusion portion 63 to position the receiver substrate 20 to the light-transmitting covering plate 32 with high accuracy.

A step between the covering plate placing portion 61 and the receiver substrate placing portion 62 is formed so as to have a height equal to the height H2 of the covering portion 30. With this configuration, the parallelism and spacing (the height H1 of the sealing frame 31) between the receiver substrate 20 and the light-transmitting covering plate 32 can be defined with high accuracy, so the covering portion 30 (sealing frame 31) can be formed with high accuracy and a good yield.

An inner step portion 64 that has a height between the covering plate placing portion 61 and the receiver substrate placing portion 62 is formed between the covering plate placing portion 61 and the receiver substrate placing portion 62. The inner step portion 64 is a region that allows for excess silicone resin so that the sealing frame 31 can secure a proper height H1 even when the resin (silicone resin) that constitutes a sealing frame 31 is applied excessively and is squeezed from the outer perimeter of the light-transmitting covering plate 32 when bonding the sealing frame 31 and the light-transmitting covering plate 32.

Outside the receiver substrate placing portion 62 (receiver substrate 20), an outer step portion 65, which is similar to the inner step portion 64, that has a height between the covering plate placing portion 61 and the receiver substrate placing portion 62 is formed. The outer step portion 65 is a space provided to allow the receiver substrate 20 to which the light-transmitting covering plate 32 is bonded with the sealing frame 31 to be readily removed from the covering plate bonding jig 60. That is, with this allowance space of the outer step portion 65, the side of the receiver substrate 20 can be held, so the receiver substrate 20 can be readily removed from the covering plate bonding jig 60 (FIG. 6(C)).

After the light-transmitting covering plate 32 is placed on the covering plate placing portion 61, a receiver substrate 20 (mount connection holes 20h) on which the sealing frame 31 was formed by the application of silicone resin is positioned on the covering plate bonding jig 60 (positioning protrusion portions 63) (FIG. 6(B)). In this state, the receiver substrate 20 is moved in the direction of the arrow C (FIG. 6(B)) to place it on the covering plate bonding jig 60 (receiver substrate placing portion 62) (FIG. 6(C)).

Before the receiver substrate 20 (sealing frame 31) is bonded to the light-transmitting covering plate 32, as already described, the height H1a of the sealing frame 31 is made larger than the height H1. Because the step between the covering plate placing portion 61 and the receiver substrate placing portion 62 has a height H2 (the sum of the thickness t3 of the light-transmitting covering plate 32 and the height H1 of the sealing frame 31), the sealing frame 31 is shaped to have a height H1 by being pressed by the light-transmitting covering plate 32 (and receiver substrate 20) in the sealing frame bonding step (FIG. 6(C)).

After the sealing frame bonding step, in the state in which the light-transmitting covering plate 32 and the receiver substrate 20 are placed on the covering plate bonding jig 60, the covering plate bonding jig 60 is heat treated in a heat treatment furnace (not shown) (heat treatment step). The sealing frame 31 (silicone resin) is cured by the heat treatment, and the shape (height H1) is thereby defined. The heat treatment can be performed under such conditions as, for example, 150°C for 30 minutes, as stated above.

Using the covering plate bonding jig 60 including the covering plate placing portion 61 and the receiver substrate placing portion 62, the sealing frame 31 can be shaped so that the parallelism and spacing between the receiver substrate 20 and the light-transmitting covering plate 32 are defined with high accuracy, so a large number of solar-cell sealing frames can be formed with good uniformity and stability, and it is therefore possible to provide a solar cell manufacturing method having a high yield and high productivity.

By configuring the inner step portion 64 and the outer step portion 65 to have the same height, they can be formed simultaneously, so the covering plate bonding jig 60 can be formed readily at a low cost.

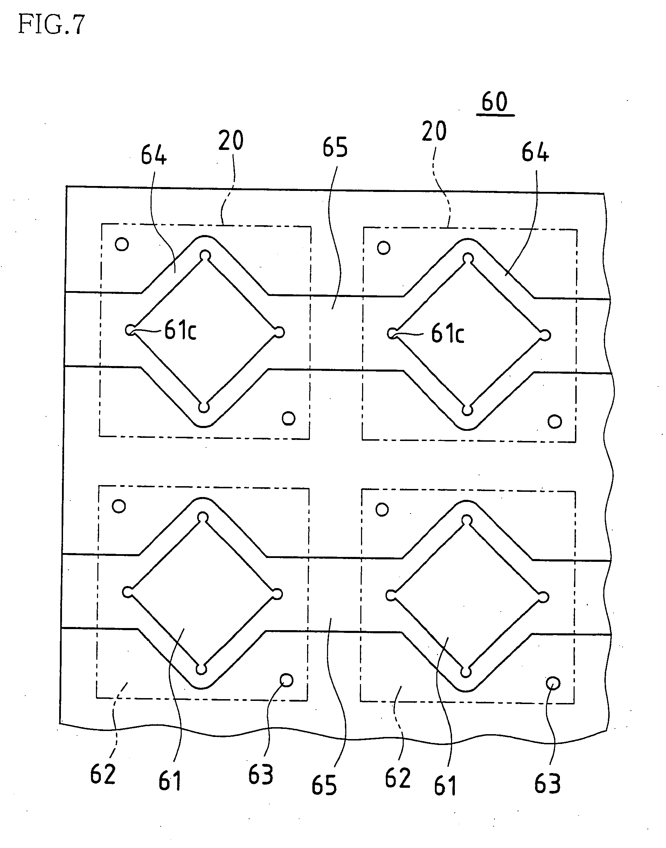

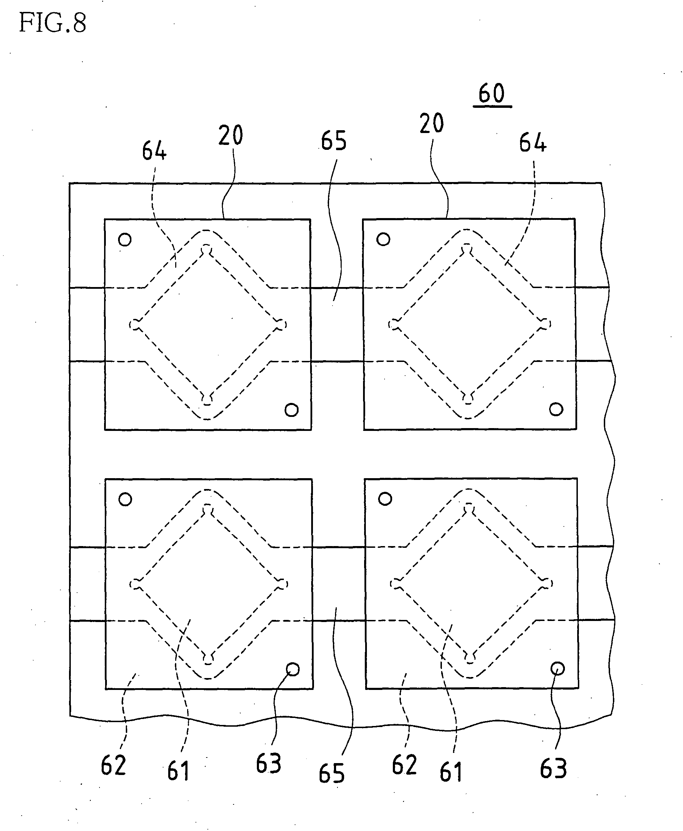

FIG. 7 is a plan view showing an example of the covering plate bonding jig shown in FIG. 6. FIG. 8 is a plan view showing a state in which receiver substrates are placed on the covering plate bonding jig shown in FIG. 7.

A covering plate bonding jig 60 according to the present example is formed as a single plate-like preform in which a plurality of covering plate placing portions 61 are formed in a matrix pattern so that a plurality of receiver substrates 20 to which light-transmitting covering plates 32 are bonded can be heat treated simultaneously. Likewise, a plurality of receiver substrate placing portions 62 are formed so as to correspond to the plurality of covering plate placing portions 61. The basic configuration of the covering plate bonding jig 60 (for example, the cross-sectional structure) is as shown in FIG. 6, and thus description is omitted where appropriate.

FIG. 7 shows a case where four covering plate placing portions 61 are arranged (in a 2×2 matrix), but it is also possible to form, for example, a total of twenty covering plate placing portions 61 (in a 4×5 matrix) so that twenty receiver substrates 20 can be treated collectively. Because the receiver substrates 20 (rectangular) are arranged in a matrix pattern (square pattern), the area density can be improved to the highest degree possible.

In the covering plate bonding jig 60, a covering plate placing portion 61 is formed in the center portion of a corresponding position (indicated by a dashed double-dotted line) in which a receiver substrate 20 is to be disposed, and a receiver substrate placing portion 62 and a positioning protrusion portion 63 are formed around the covering plate placing portion 61. An inner step portion 64 is formed between the covering plate placing portion 61 and the receiver substrate placing portion 62.

Outside a receiver substrate placing portion 62 (receiver substrate 20), an outer step portion 65, which is similar to the inner step portion 64, is formed. In this example, the outer step portion 65 is formed as an extended portion of the inner step portion 64, and is continuously formed extending between adjacent receiver substrates 20.

Because the outer step portions 65 are continuous along one direction, they can be readily formed, and the workability for receiver substrates 20 (placement and removal operations) can be improved.

The covering plate placing portion 61, the inner step portion 64, and the outer step portion 65 can be formed by counterboring recesses (grooves) in a plate-like preform. Also, a cut portion 61c that forms a cylindrical space is formed in a wall corner of the covering plate placing portion 61. The cut portions 61c prevent breakage of the corners of the light-transmitting covering plate 32 that is disposed facing the covering plate placing portion 61, so an improved yield can be obtained.

Because a heat treatment in a heat treatment furnace (not shown) can be performed in a state as shown in FIG. 8 in which a plurality of receiver substrates 20 are stably disposed in the covering plate bonding jig 60, the covering plate bonding step can be performed with very high accuracy and good productivity. Note that the light-transmitting covering plate 32 and the like are not shown in FIG. 8.

After the heat treatment step is finished, each receiver substrate 20 to which a light-transmitting covering plate 32 is bonded with the sealing frame 31 is removed from the covering plate bonding jig 60. After that, a resin sealing portion 33 is formed in a sealing region defined by the sealing frame 31 and the light-transmitting covering plate 32 formed on each individual receiver substrate 20 (resin sealing step).

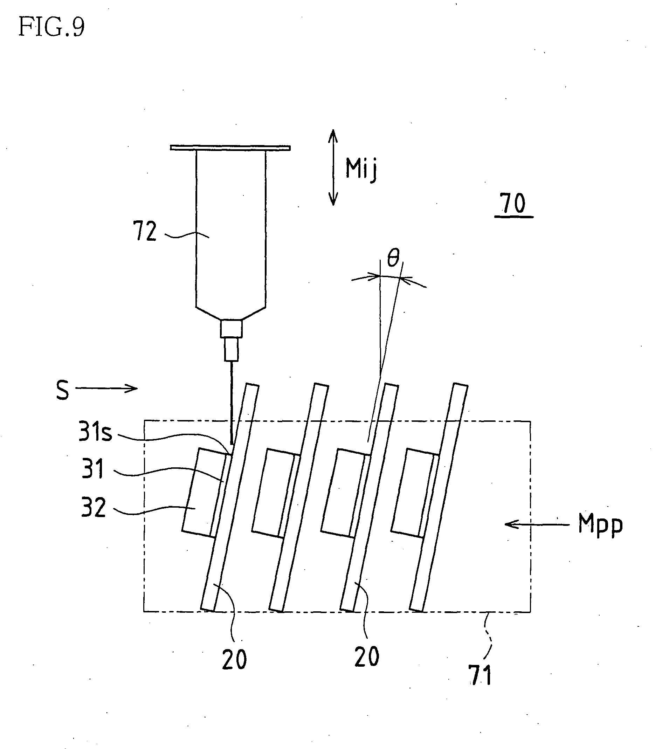

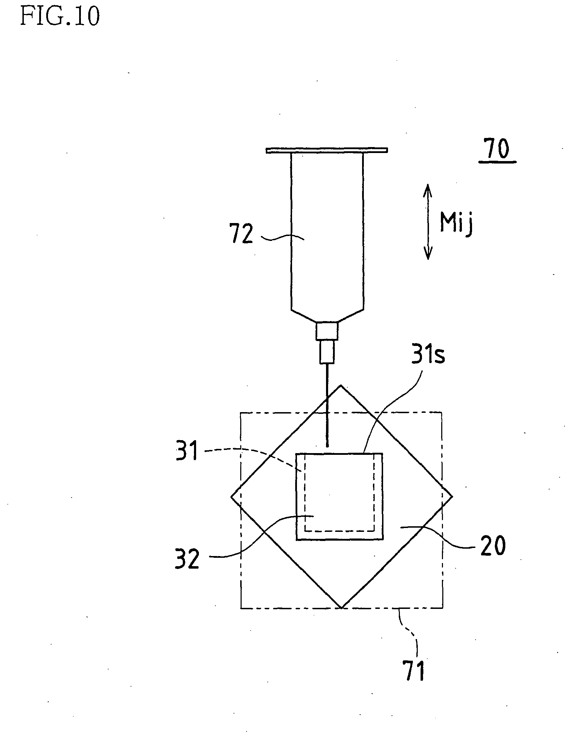

FIG. 9 is a process explanatory diagram illustrating the resin sealing step shown in FIG. 5 in further detail, and is a schematic side view conceptually showing a state in which a plurality of receiver substrates are arranged side by side in a substrate juxtaposition jig and sealing resin is filled using a resin injector. FIG. 10 is a schematic front view showing a state as viewed from the direction of the arrow S of FIG. 9.

The resin sealing step of Embodiment 2 involves a substrate juxtaposing step of arranging receiver substrates 20 side by side in a substrate juxtaposition jig 71 with the openings 31s positioned horizontally in the upper portion of the sealing frames 31; a resin filling step of filling (injecting) the sealing regions with sealing resin through the openings 31s of the receiver substrates 20, which are arranged side by side in the substrate juxtaposition jig 71, using a resin injector 72 so as to prepare a resin sealing portion 33, the sealing regions being defined by the sealing frame 31 and the light-transmitting covering plate 32; and a heat treatment step of heat treating the substrate juxtaposition jig 71 in which the receiver substrates 20 sealed with the sealing resin are placed in a heat treatment furnace (not shown) to cure the resin so as to form resin sealing portions 33.

The substrate juxtaposition jig 71 in which a plurality of receiver substrates 20 are arranged side by side and the resin injector 72 for injecting sealing resin together constitute a solar cell manufacturing apparatus 70. That is, the solar cell manufacturing apparatus 70 is an apparatus used in the resin sealing step (the resin filling step in particular) of forming resin sealing portions 33.

The substrate juxtaposition jig 71 is configured to move at an equal pitch in the horizontal direction (the arrow Mpp), and the resin injector 72 is configured to move in the perpendicular direction (the arrow Mij). Accordingly, it is possible to sequentially fill a plurality of receiver substrates 20 (sealing regions) that are arranged side by side with sealing resin. Because the substrate juxtaposition jig 71 is subjected to the resin sealing step after a plurality of receiver substrates 20 are arranged side by side, it is possible to form resin sealing portions 33 stably with good productivity.

Specifically, the resin injector 72 moves perpendicularly upward (the arrow Mij) after the filling of each receiver substrate 20 with sealing resin is finished. As the resin injector 72 moves, the substrate juxtaposition jig 71 is moved horizontally (the arrow Mpp) in the left direction of FIG. 9 to position the next receiver substrate 20 to be filled below the resin injector 72. In this state, the resin injector 72 is moved perpendicularly downward, and the corresponding receiver substrate 20 is filled with sealing resin.

By sequentially repeating the perpendicular movement of the resin injector 72 and the horizontal movement of the substrate juxtaposition jig 71, resin sealing portions 33 can be formed in a plurality of receiver substrates 20 readily and rapidly with good productivity. That is, by combining the substrate juxtaposition jig 71 and the resin injector 72, sealing resin can be supplied to a plurality of solar cell elements 11 in a stable manner, readily forming resin sealing portions 33. Accordingly, a solar cell manufacturing apparatus 70 with which solar cells can be manufactured with good productivity can be obtained.

The substrate juxtaposition jig 71 has a configuration in which receiver substrates 20 are arranged side by side with the receiver substrates 20 being inclined relative to the perpendicular direction so that the sealing frame 31 (light-transmitting covering plate 32) is positioned upward relative to the receiver substrate 20. That is, the receiver substrates 20 are inclined so that the openings 31s can be visually recognized from above in the perpendicular direction. Accordingly, the sealing resin injected from the resin injector 72 into the opening 31s can flow along the surface of the receiver substrate 20 at a flow gradient θ, so smooth resin flow can be achieved, and the sealing regions can be filled with sealing resin in a stable manner.

It is preferable that the flow gradient θ is set to approximately 5 to 10 degrees relative to the perpendicular direction in consideration of the balance between preventing the incorporation of air bubbles, shortening the filling time, and the like.

The resin injector 72 is disposed such that it can fill a sealing region with sealing resin at a position shifted to either the right or left relative to the center in the horizontal direction of the opening 31s (FIG. 10). With this configuration, the flow of resin can be made smoother, further reducing the incorporation of air bubbles into the sealing resin, and making it easy to remove bubbles. Accordingly, resin sealing portions 33 in which few air bubbles are included can be formed with a good yield.

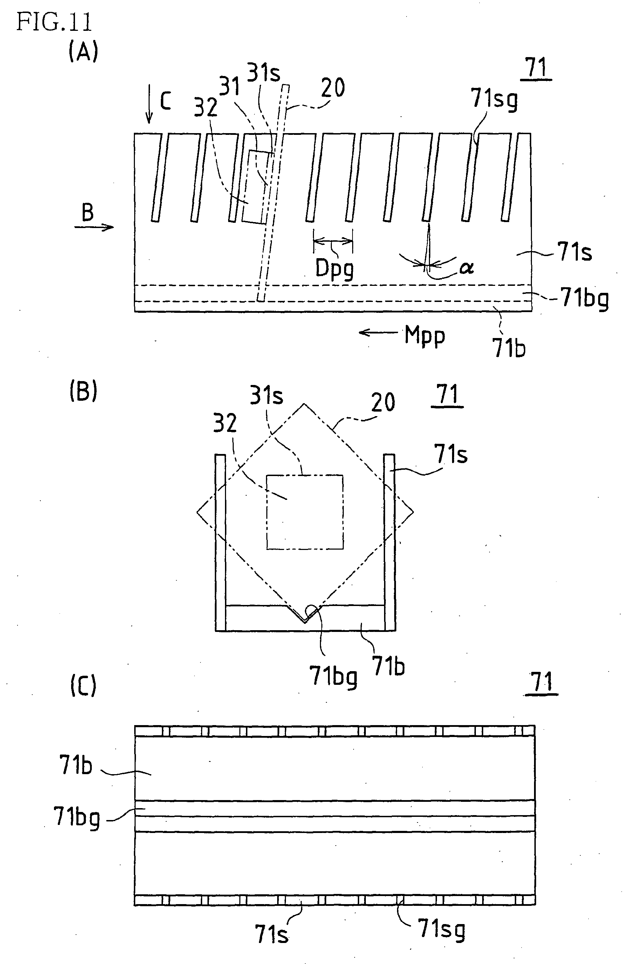

FIG. 11 is an explanatory diagram illustrating an example of the substrate juxtaposition jig shown in FIG. 9. FIG. 11(A) is a front view illustrating a state, taken in the same direction as FIG. 9. FIG. 11(B) is a side view as viewed from the direction of the arrow B of FIG. 11(A). FIG. 11(C) is a plan view as viewed from the direction of the arrow C of FIG. 11(A). For reference, FIG. 11(A) and FIG. 11(B) show a state in which one receiver substrate 20 is disposed.

As described above, the substrate juxtaposition jig 71 has a configuration in which a plurality of receiver substrates 20 are arranged side by side with the openings 31s facing upward. The substrate juxtaposition jig 71 includes a juxtaposition base plate 71b having a substrate placing groove 71bg to which one of the corners of a receiver substrate 20 makes contact so as to place (support) the receiver substrate, and juxtaposition side plates 71s that are erected on both sides of the juxtaposition base plate 71b and each have substrate engaging grooves 71sg for engaging two facing corners of a receiver substrate 20.

The substrate juxtaposition jig 71 is formed so as to have 10 pairs of substrate engaging grooves 71sg, so that ten receiver substrates 20 can be arranged side by side. The substrate engaging grooves 71sg are formed at an equal arrangement spacing Dpg so as to correspond to the equal pitch movement in the horizontal direction. By moving the substrate juxtaposition jig 71 so as to correspond to the arrangement spacing Dpg, equal pitch movement in the horizontal direction (the arrow Mpp) can be made possible.

In order to facilitate the horizontal positioning of opening 31s, the substrate placing groove 71bg is formed into a V shape so that two sides forming a corner of the receiver substrate 20 come into contact with that V shape. That is, a receiver substrate 20 is placed with two sides forming a corner of the receiver substrate in contact with the substrate placing groove 71bg, and it thereby becomes possible to juxtapose receiver substrates 20 in the substrate juxtaposition jig 71 with great ease.

The substrate engaging groove 71sg is formed to have an angle of inclination α (= flow gradient θ) relative to the perpendicular direction so as to equal the above-mentioned flow gradient θ of the sealing resin. Accordingly, juxtaposition of receiver substrates 20 in the substrate juxtaposition jigs 71 (engagement of the substrates in the substrate engaging grooves 71sg) can readily impart the sealing resin with the flow gradient θ.

After the filling of a plurality of receiver substrates 20 arranged side by side in the substrate juxtaposition jig 71 (resin filling step) with sealing resin is finished, the substrate juxtaposition jig 71 in which receiver substrates 20 are juxtaposed is separated from the solar cell manufacturing apparatus 70, and heat treated in a heat treatment furnace (not shown) to cure the sealing resin (heat treatment step). As above, the heat treatment can be performed under such conditions as, for example, 150°C for 30 minutes.

Because the receiver substrates 20 are heat treated while maintaining a state in which the receiver substrates 20 are arranged side by side in the substrate juxtaposition jig 71 (a state in which the receiver substrates 20 are leaning with the openings 31s positioned upward), the air bubbles incorporated when filling sealing resin can be readily removed from the opening 31s before curing, so a resin sealing step with a good yield and productivity, from which sealing resin can be easily removed can be achieved.

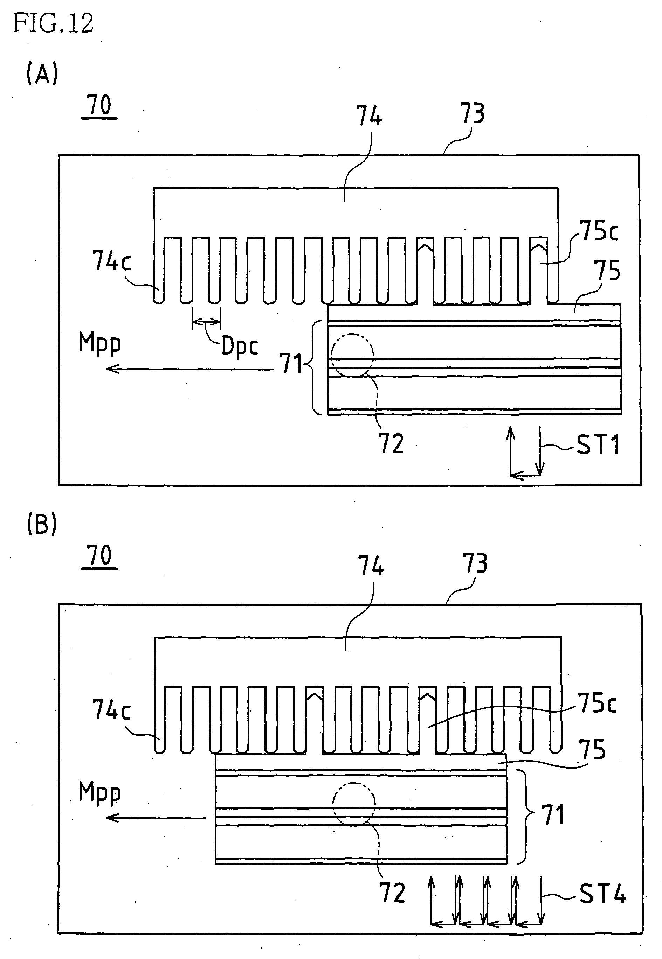

FIG. 12 is an explanatory diagram illustrating a horizontal movement mechanism with which the substrate juxtaposition jig of the solar cell manufacturing apparatus shown in FIG. 9 moves horizontally at an equal pitch. FIG. 12(A) is a plan view of the horizontal movement mechanism showing a state before horizontal movement is performed. FIG. 12(B) is a plan view of the horizontal movement mechanism showing a state after horizontal movement is performed by a distance equal to four receiver substrates.

The solar cell manufacturing apparatus 70 includes an equal pitch scale 74 that is fixed to a work stage 73. The equal pitch scale 74 has comb-like protrusion portions 74c formed at an arrangement spacing Dpc that is equal to the arrangement spacing Dpg of the substrate engaging groove 71sg. The substrate juxtaposition jig 71 is connected to a moving scale 75 having comb-like protrusion portions 75c formed to correspond to the comb-like protrusion portions 74c.

The comb-like protrusion portions 74c and the comb-like protrusion portions 75c are configured to have a comb-like shape so that they fit each other, and thereby, the positioning accuracy of the horizontal movement (the arrow Mpp) of the substrate juxtaposition jig 71 is secured. It is sufficient that at least one comb-like protrusion portion 75c is provided. Here, in order to secure mechanical strength and accuracy, two comb-like protrusion portions 75c formed with a spacing that is four times the arrangement spacing Dpc are provided.

The equal pitch scale 74 and the moving scale 75 together can form a horizontal movement mechanism. That is, by moving the moving scale 75 (and the substrate juxtaposition jig 71) along a path shown by a unit stroke ST1 corresponding to one of the comb-like protrusion portions 74c, the substrate juxtaposition jig 71 can be readily moved horizontally. In order to secure the stroke movement, a guide groove for engaging with the substrate juxtaposition jig 71 may be provided in the work stage 73.

The resin injector 72 is fixed relative to the horizontal direction. Accordingly, by horizontally moving the substrate juxtaposition jig 71 so as to correspond to the unit stroke ST1, the resin injector 72 can sequentially fill adjacent receiver substrates 20 (openings 31s) with sealing resin. To simplify the drawing, the resin injector 72 is not shown.

That is, by sequentially repeating the unit stroke ST1, the substrate juxtaposition jig 71 can be moved at an equal pitch of arrangement spacing Dpc that is equal to the arrangement spacing Dpg. Accordingly, a plurality of receiver substrates 20 placed in the substrate juxtaposition jig 71 can be sequentially filled with sealing resin.

FIG. 12(B) shows a state in which the substrate juxtaposition jig 71 is moved horizontally so as to correspond to the distance equal to four receiver substrates with, for example, a stroke ST4 that is four times the unit stroke ST1. The relative position between the resin injector 72 and the substrate juxtaposition jig 71 changes corresponding to the distance equal to four times the arrangement spacing Dpg. That is, receiver substrates 20 can be filled sequentially with sealing resin through correspondence with the horizontal movement of the substrate juxtaposition jig 71.

As described above, a plurality of solar cell elements 11 can be sequentially filled with sealing resin in a stable manner, and resin sealing portions 33 can be readily formed. Accordingly, a solar cell manufacturing apparatus 70 with superior yield and productivity can be obtained.

### <Embodiment 3>

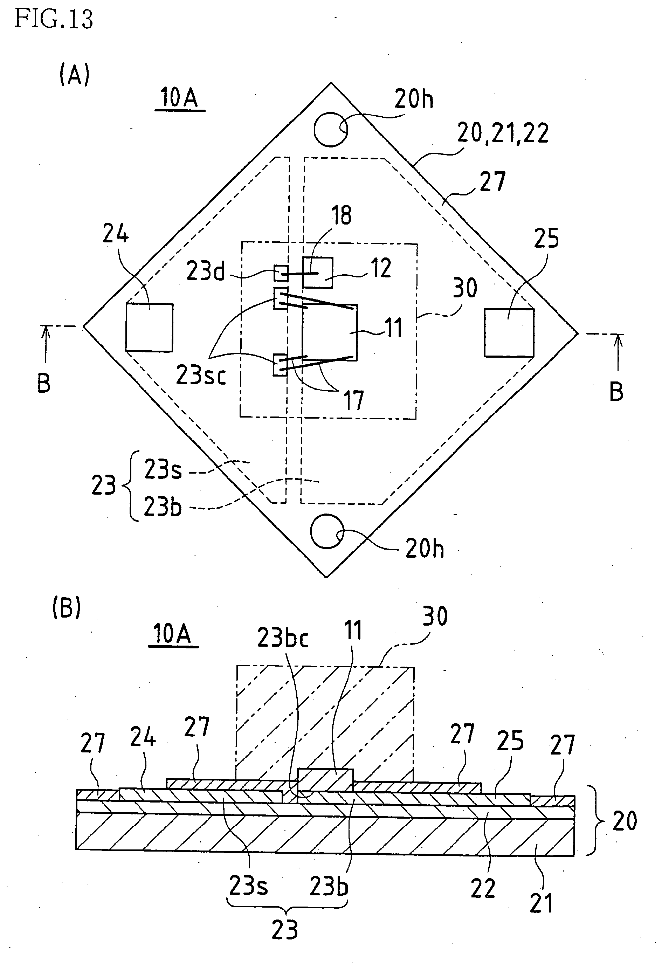

A solar cell according to Embodiment 3 of the present invention will be described with reference to FIGS. 13(A) to 14.

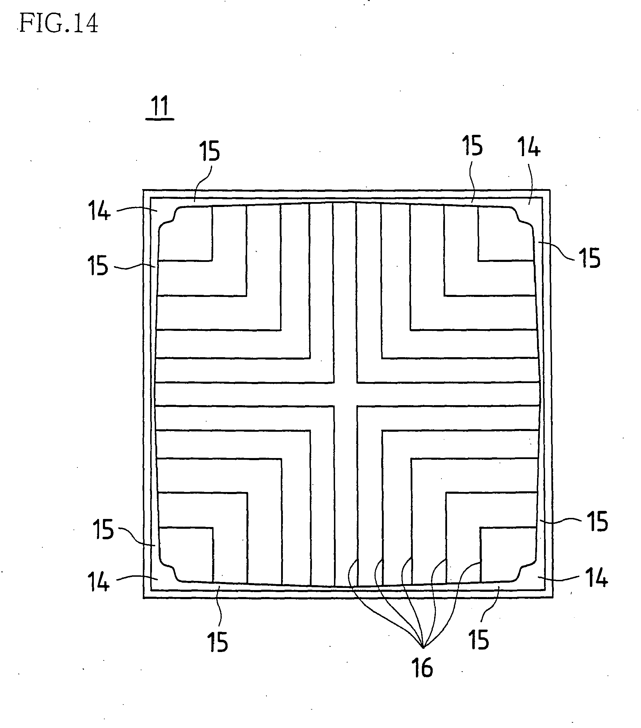

FIGS. 13(A) and 13(B) are explanatory diagrams illustrating a solar cell according to Embodiment 3 of the present invention. FIG. 13(A) is a plan view and FIG. 13(B) is a cross-sectional view showing a state of the cross section taken along the line B-B of FIG. 13(A). FIG. 14 is an enlarged plan view showing a state of the surface electrode of the solar cell element shown in FIGS. 13(A) and 13(B).

A solar cell 10A of Embodiment 3 includes a concentrating solar cell element 11 that generates power by converting concentrated and directed sunlight into electricity, and a receiver substrate 20 on which the solar cell element 11 is placed. The solar cell element 11 is connected to a bypass diode 12 in parallel.

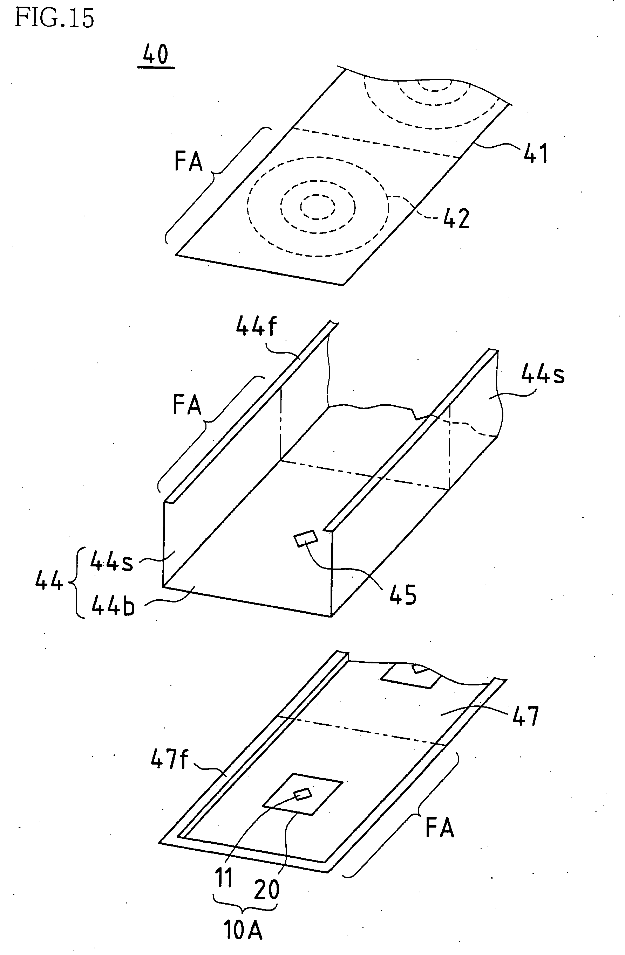

The bypass diode 12 secures a current path in the case where the solar cell element 11 acts as a resistor when sunlight is blocked or the like, and is configured such that, even if a particular solar cell element 11 fails to perform its power generation function when, for example, a concentrating solar power generation unit 40 (see FIG. 15) is constituted by connecting a plurality of solar cell elements 11, the power generation function as a whole can be maintained.

The solar cell element 11 is an approximately 5 to 10 mm-square chip obtained from a wafer by forming a PN junction, electrodes (substrate electrode and surface electrode), and so on, by known semiconductor manufacture processes using, for example, a GaAs-based compound semiconductor.

The solar cell element 11 includes, as electrodes, a substrate electrode (not shown) disposed on the substrate side of the chip and a surface electrode 14 disposed on the surface side of the chip (see FIG. 14). The surface electrodes 14 are formed on the four corners of a chip. The surface electrodes 14 are integrated with current collector electrodes 15 that extend along the four sides of a semiconductor substrate and branch electrodes 16 that extend in the diagonal direction of the chip from the current collector electrodes 15 to intersect with the sides of the chip and that form L-shaped electrodes with a shape symmetrical with respect to the diagonal line of the chip.

With this electrode configuration, the solar cell element 11 can collect generated current with each current collector electrode 15 at the shortest distance and output the current from each surface electrode 14, so a solar cell 10A can be obtained in which a voltage drop due to resistance in the current path or the like is small and current collecting efficiency is improved. As the electrode material, for example, silver, titanium or the like can be used.

The current collector electrode 15 is formed such that it becomes thin at the center portion of each side of the chip and thick on the surface electrode 14 side to achieve a balance between securing a photoelectric conversion area and the characteristic reduction due to resistance in the current path, and thereby improving the photoelectric conversion efficiency.

The receiver substrate 20 includes a base 21, an intermediate insulating layer 22 laminated onto the base 21, a connection pattern layer 23 laminated onto the intermediate insulating layer 22, and a surface protection layer 27 that protects the connection pattern layer 23. The receiver substrate 20 is, for example, a 40 to 80 mm square relative to, for example, an approximately 8 to 10 mm-square solar cell element 11. The layers of the receiver substrate 20 can be laminated using an appropriate adhesive or the like.

The base 21 is formed of, for example, an aluminum plate, and has a thickness of, for example, approximately 1 to 4 mm. Because an aluminum plate is used, heat dissipation properties can be improved, and a weight reduction can be achieved. It is also possible to use a copper plate or the like in place of an aluminum plate.

The intermediate insulating layer 22 is made of, for example, an epoxy-based resin material that has a high content of a highly heat conductive inorganic filler (for example, aluminum), and has a thickness of, for example, approximately 50 to 100 µm. Using an epoxy-based resin material that has a high content of a highly heat conductive inorganic filler (for example, aluminum), the solar cell element 11 can be readily and reliably insulated from the base 21 via a thin insulating film (intermediate insulating layer 22). Accordingly, the base 21 can be effectively utilized as a heat dissipating means having a high heat-dissipation efficiency, and a highly reliable solar cell 10A can be obtained readily.

The connection pattern layer 23 is formed of, for example, a copper foil, and has a thickness of, for example, approximately 50 to 100 µm. The connection pattern layer 23 is configured from a surface electrode connection pattern 23s, to which the surface electrode 14 of the solar cell element 11 is connected; and a substrate electrode connection pattern 23b, to which the substrate electrode of the solar cell element 11 is connected.

By forming the connection pattern layer 23 with a copper foil, the connection to the surface electrode 14 and the substrate electrode of the solar cell element 11 can be secured in an easy and reliable manner, and a connection to the electrodes of the solar cell element 11 can be readily established via external terminals (a surface electrode output terminal 24 and a substrate electrode output terminal 25 that are formed at respective ends of the connection pattern layer 23).

The substrate electrode of the solar cell element 11 is bonded to a substrate electrode connection portion 23bc, which is a connection region of the substrate electrode connection pattern 23b, by, for example, soldering or the like. The surface electrode 14 of the solar cell element 11 is connected to a surface electrode connection portion 23sc, which is a connection region of the surface electrode connection pattern 23s via a wire 17. The surface electrode of the bypass diode 12 is connected to a surface electrode connection portion 23d, which is a connection region of the surface electrode connection pattern 23s, via a wire 18. The wires 17 and 18 are formed of, for example, 250 µm ø aluminum wire, and are bonded with ultrasonic eutectic. In FIG. 13(B), the wires 17 and 18 are not shown.

The surface protection layer 27 is formed of, for example, a solder resist, and has a thickness of, for example, approximately 50 µm. The surface protection layer 27 is configured for protection such that it covers the surface of the receiver substrate 20 excluding the regions where connection is necessary (for example, the substrate electrode connection portion 23bc, the surface electrode connection portion 23sc, the surface electrode connection portion 23d, the surface electrode output terminal 24, and the substrate electrode output terminal 25, etc.). With this surface protection layer 27, the insulation between the substrate electrode connection pattern 23b and the surface electrode connection pattern 23s can be reliably improved, further improving the reliability of the solar cell 10A.

A surface electrode output terminal 24 serving as a connection region is formed at an end of the surface electrode connection pattern 23s, and a substrate electrode output terminal 25 serving as a connection region is formed at an end of the substrate electrode connection pattern 23b. Because the surface protection layer 27 is not formed on the surface electrode output terminal 24 and the substrate electrode output terminal 25, the surface electrode output terminal 24 and the substrate electrode output terminal 25 can be used to work as output terminals to the outside of the solar cell 10A, so adjacent solar cells 10A can be connected with appropriate connection wires (not shown).

In the solar cell 10A according to Embodiment 3, because the solar cell element 11 is insulated from the base 21, the surface electrode 14 and the substrate electrode of the solar cell element 11 can be connected to the connection pattern layer 23, and respective independent terminals (the surface electrode output terminal 24 and the substrate electrode output terminal 25) can be obtained. Accordingly, by forming the base 21 with a metal that has a high heat conductivity, the base 21 can be effectively utilized as a heat dissipating means with a high heat-dissipation efficiency. Accordingly, the solar cell 10A will be a solar cell with a simple structure that has high insulation capabilities, heat dissipation properties, superior reliability and good power generation efficiency.

In the receiver substrate 20, a pair of mount connection holes 20h for mounting and fixing the solar cell 10A (receiver substrate 20) to a solar cell mounting plate 47 (see FIG. 15) are formed at the diagonal. The mount connection holes 20h are arranged in different corners from the corners where the surface electrode output terminal 24 and the substrate electrode output terminal 25 are provided so as to be easily insulated from each other.

In order to protect the solar cell element 11 and the bypass diode 12, a covering portion 30 having an appropriate shape is formed in the center portion of the receiver substrate 20 such that the covering portion 30 covers the solar cell element 11 and the bypass diode 12. To facilitate description and understanding, the covering portion 30 may not be shown in the diagrams where appropriate.

In the solar cell 10A according to Embodiment 3, the solar cell element 11 and the receiver substrate 20 both have a rectangular shape, and the solar cell element 11 is disposed such that each side intersects the diagonal line of the receiver substrate 20. The covering portion 30 is formed to have a shape (rectangular shape) corresponding to the rectangular shape of the solar cell element 11. The rectangular shape is preferably a square, and it is preferable that each side and each diagonal line intersect perpendicular to each other, but the configuration is not limited to this.

Due to the relationship between the arrangement of the solar cell element 11 and the arrangement of the receiver substrate 20, when the solar cell 10A is applied to a concentrating solar power generation unit 40 by being mounted on a solar cell mounting plate 47, the sides of the solar cell element 11 and the covering portion 30 can be inclined relative to the perpendicular direction. Accordingly, it is possible to prevent water that has entered from the outside from remaining in a position corresponding to each side of the solar cell element 11 (covering portion 30), so a solar cell with improved moisture resistance and improved weather resistance can be obtained.

### <Embodiment 4>

A concentrating solar power generation unit according to Embodiment 4 of the present invention will be described with reference to FIGS. 15 to 19.

FIG. 15 is an exploded perspective view showing an overall configuration of a concentrating solar power generation unit according to Embodiment 4 of the present invention.

A concentrating solar power generation unit 40 according to Embodiment 4 includes a light-transmitting protection plate 41 disposed so as to correspond to the top face of the concentrating solar power generation unit 40, a concentrating lens 42 that is fixed to the back face of the light-transmitting protection plate 41 (the lower side of FIG. 15) and that concentrates sunlight, and an elongated frame 44 serving as the basic structure of the concentrating solar power generation unit 40.

The elongated frame 44 is formed so as to have a U shape that is configured from side portions 44s and a bottom portion 44b. The side portions 44s are configured to be capable of holding the light-transmitting protection plate 41 and are adjusted to have a height so that a solar cell 10A corresponds with the focal distance of the concentrating lens 42. The bottom portion 44b is configured so as to be capable of holding a pair of facing side portions 44s and of attaching the solar cell mounting plate 47, on which the solar cell 10A is mounted, at the back face thereof (the lower side of FIG. 15).

The light-transmitting protection plate 41 is made of, for example, glass considering its light-transmitting properties, strength, environmental resistance and the like, and is configured so as to be capable of excluding the influence of wind and rain from the surrounding environment. It is also possible to use acrylic resin, polycarbonate, or the like in place of glass.

A plurality of concentrating lenses 42 are arranged in a row in the light-transmitting protection plate 41 to correspond to solar cells 10A, thereby constituting a lens array. The concentrating lenses 42 are bonded to the light-transmitting protection plate 41 with an appropriate adhesive. The concentrating lenses 42 are formed of, for example, acrylic resin, considering its processability, light-transmitting capabilities and the like. It is also possible to use polycarbonate, glass or the like instead of acrylic resin.

The elongated frame 44 is formed as a single body including the side portions 44s and the bottom portion 44b by, for example, roll forming a metallic plate such as an iron plate or steel plate. An appropriate flange 44f for fixing the light-transmitting protection plate 41 is formed on the top face of the elongated frame 44. Also, a sunlight application hole 45 for directing sunlight concentrated by the concentrating lens 42 to the solar cell 10A is formed in the bottom portion 44b. By forming the elongated frame 44 with a metallic plate such as an iron plate or steel plate, mechanical strength and weather resistance can be secured.

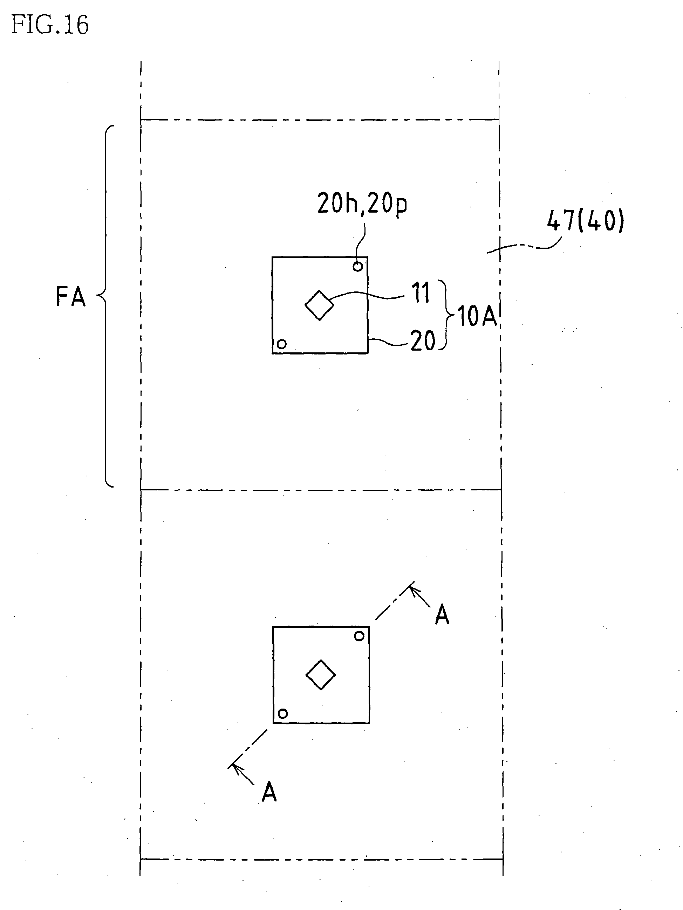

The solar cell mounting plate 47 is also elongated similar to the elongated frame 44, and is configured such that a plurality of solar cells 10A are mounted in a row in the length direction (see FIG. 16). The solar cell mounting plate 47 is formed from, for example, an aluminum plate, considering the weight reduction and heat dissipation properties thereof. A solar cell 10A (solar cell element 11) is disposed so as to correspond to the center (the focal position of concentrated sunlight: sunlight application hole 45) of each light-concentrating unit region FA that is formed to correspond to each concentrating lens 42. It is also possible to attach a plurality of solar cell mounting plates 47 in the elongated frame 44.

The solar cell 10A is the same as that described in Embodiment 3, and the solar cell element 11 is placed on the receiver substrate 20. An appropriate flange 47f for attaching to the bottom portion 44b is formed around the solar cell mounting plate 47.

FIG. 16 is a plan view showing a solar cell arrangement in which the concentrating solar power generation unit shown in FIG. 15 is mounted on a solar cell mounting plate.

A solar cell 10A is disposed in the center of a light-concentrating unit region FA of the solar cell mounting plate 47. The solar cell mounting plate 47 is formed so as to have a rectangular shape, considering the ease with which solar cells 10A can be mounted, and the like, and a plurality of solar cells 10A are arranged in a row in the length direction. Here, an arrangement with only one row is shown, but an arrangement with an appropriate number of rows, (for example, two rows) may be used instead, for example, ten (2×5) solar cells 10A as a whole can be arranged in the solar cell mounting plate 47.

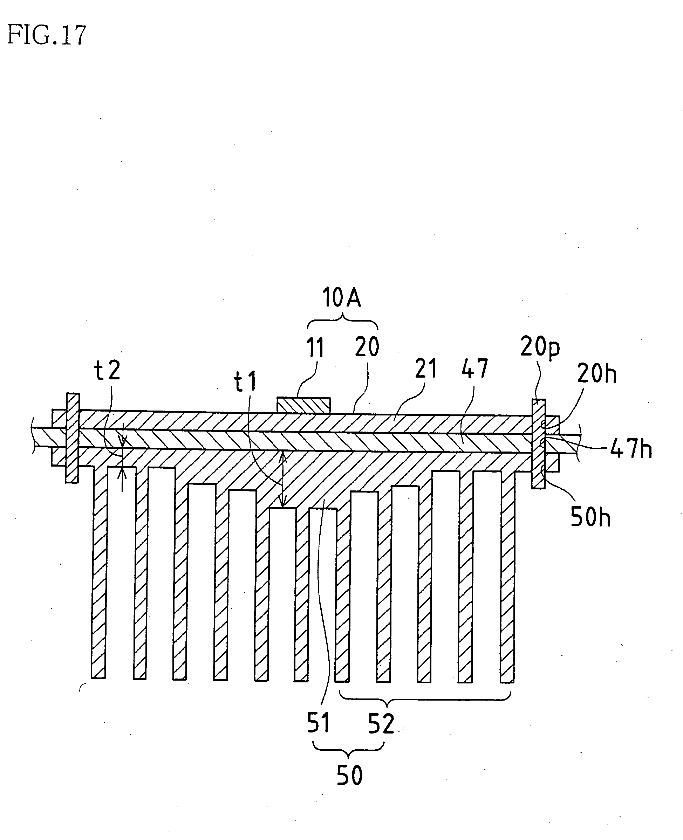

The solar cell 10A is fixed to the solar cell mounting plate 47 by positioning the mount connection holes 20h formed in the receiver substrate 20 and mount connection holes 47h (see FIG. 17) formed in the solar cell mounting plate 47 so as to correspond to the respective mount connection holes 20h, and inserting mount connection pins 20p such as rivets.

The receiver substrate 20 is disposed in parallel with the row direction (the length direction of the solar cell mounting plate 47). That is, the receiver substrate 20 is disposed such that a pair of facing sides of the receiver substrate 20 are parallel with the sides of the solar cell mounting plate 47. With this configuration, when the solar cell mounting plate 47 (concentrating solar power generation unit 40) is disposed in a direction perpendicular or horizontal to sunlight, the sides of the solar cell element 11 are inclined relative to the perpendicular direction. Accordingly, it is possible to prevent water that has entered from the outside of the concentrating solar power generation unit 40 from remaining at each side of the solar cell element 11 (covering portion 30), so the moisture resistance and weather resistance of the solar cell 10A can be improved.

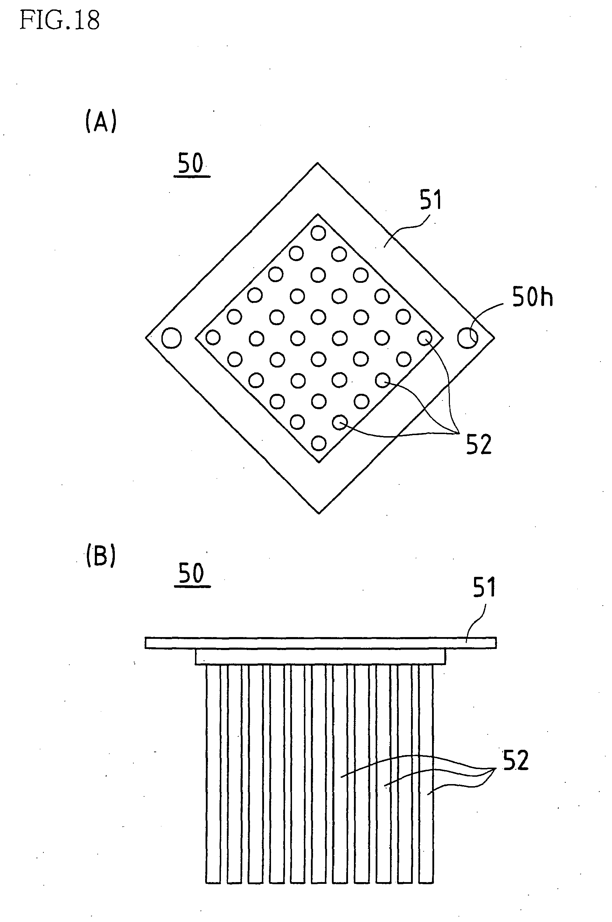

FIG. 17 is a cross-sectional view of a radiator according to Example 1 that is applied to the concentrating solar power generation unit according to Embodiment 4 of the present invention, which shows a state of the cross section taken along the A-A line of FIG. 16. FIGS. 18(A) and 18(B) are explanatory diagrams illustrating the radiator shown in FIG. 17, with FIG. 18(A) being a plan view showing a state of the tips of heat dissipating projection portions and FIG. 18(B) being a front view showing a projecting state of the heat dissipating projection portions.

Because the base 21 forming the back face of the receiver substrate 20 is insulated from the solar cell element 11, a radiator 50 can be readily disposed with a simple structure so as to correspond to the back face of the receiver substrate 20. That is, in the present example, the radiator 50 is disposed on the back face (base 21 side) of the receiver substrate 20 that is the opposite side to the surface side of the receiver substrate 20 on which the solar cell element 11 is placed so as to correspond to the solar cell element 11.

The radiator 50 according to the present embodiment includes a heat dissipating base portion 51 that has a flat plate-like surface that contacts the solar cell mounting plate 47 on the back face side thereof that is opposite to the surface side of the solar cell mounting plate 47 on which the receiver substrate 20 is mounted, and heat dissipating projection portions 52 projecting from the heat dissipating base portion 51. That is, the heat dissipating base portion 51 is configured such that it contacts the solar cell mounting plate 47 on the back face side thereof that is opposite to the surface side of the solar cell mounting plate 47 on which the solar cell 10A is mounted so as to correspond to the solar cell element 11 (receiver substrate 20).

By forming the radiator 50 by molding (extruding, casting, or the like), for example, aluminum, which is lightweight and has good processability, easy formation at a low cost and a weight reduction are possible. The heat dissipating projection portions 52 can have various shapes such as a pin shape (see FIGS. 18(A) and 18(B)), or a fin shape. By integrating the heat dissipating projection portions 52 with the heat dissipating base portion 51, heat resistance can be reduced, and heat dissipating efficiency can be further improved.

Because the receiver substrate 20 (base 21), the solar cell mounting plate 47 and the heat dissipating base portion 51 are brought into contact (connect) with each other, the mount connection holes 20h of the receiver substrate 20, the mount connection holes 47h of the solar cell mounting plate 47, and the heat dissipation connection holes 50h of the heat dissipating base portion 51 are formed such that they correspond to each other. That is, the receiver substrate 20 (base 21), the solar cell mounting plate 47, and the heat dissipating base portion 51 are brought into firm contact (fixed with application of pressure) by mount connection pins 20p that penetrate and are inserted into the mount connection holes 20h, the mount connection holes 47h, and the heat dissipation connection holes 50h. Therefore, the heat resistance of the heat dissipation path between them can be reduced, and the heat dissipation properties of the path can be improved. The mount connection pins 20p can be, for example, rivets or the like.

Because a heat dissipation path having high heat-dissipation properties can be configured with the receiver substrate 20 (base 21), the solar cell mounting plate 47, the heat-dissipating base portion 51 and the heat-dissipating projection portions 52, heat applied to the receiver substrate 20 by concentrated sunlight directed towards the solar cell element 11 can be dissipated through the path, so it is possible to obtain a concentrating solar power generation unit 40 having high heat-dissipation properties with a simple structure.

Furthermore, because the heat dissipating base portion 51 is formed such that the thickness t1 of a portion (a portion closer to the solar cell element 11) corresponding to the solar cell element 11 is increased relative to the thickness t2 of a portion away from the solar cell element 11, the heat resistance of the heat dissipation path can be reliably reduced, so it is possible to obtain a concentrating solar power generation unit 40 having even higher heat dissipation properties.

As described above, according to Embodiment 4, because the radiator 50 having high heat-dissipation properties with a simple structure is disposed so as to correspond to each solar cell element 11, it is possible to obtain a concentrating solar power generation unit 40 in which weight reduction is possible, and the heat dissipation properties and power generation efficiency are high. In addition, because the radiator 50 has a structure in which the heat dissipating means is simplified, good productivity and a reduction in manufacturing cost can be achieved.

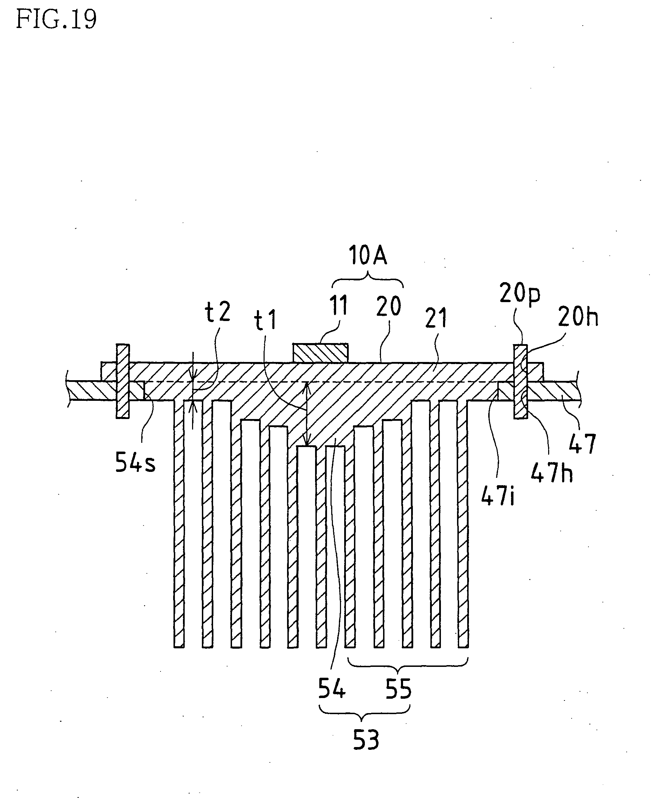

FIG. 19 is a cross-sectional view of a radiator according to Example 2 that is applied to the concentrating solar power generation unit according to Embodiment 4 of the present invention, which shows a state of the cross section taken along the A-A line of FIG. 16.

The radiator 53 according to the present example is a variation of the radiator 50 of Example 1. Accordingly, mainly the differences from Example 1 will be described. As in Example 1, the radiator 53 is disposed on the back face side (base 21 side) that is the opposite side to the surface side of the receiver substrate 20 on which the solar cell element 11 is placed, so as to correspond to the solar cell element 11.

The radiator 53 includes a heat dissipating base portion 54 integrated with the receiver substrate 20 (base 21) and heat dissipating projection portions 55 projecting from the heat dissipating base portion 54. That is, as in Example 1, a solar cell 10A is configured to include a radiator 53 having a heat dissipating base portion 54 and heat dissipating projection portions 55.

Because the receiver substrate 20 and the heat dissipating base portion 54 are integrated, only by fixing the receiver substrate 20 to the solar cell mounting plate 47 with the mount connection pins 20p that penetrate and are inserted into the mount connection holes 20h of the receiver substrate 20 and the mount connection holes 47h of the solar cell mounting plate 47, the radiator 53 is also fixed to the solar cell mounting plate 47. That is, the task of connecting the radiator 53 to the solar cell mounting plate 47 can be omitted to simplify the manufacturing process, so it is possible to obtain a concentrating solar power generation unit 40 having high heat-dissipation properties with a simple assembly.

Because the receiver substrate 20 and the heat dissipating base portion 54 are integrated, the heat resistance of the heat dissipation path can be further reduced as compared to the radiator 50 of Example 1, so the heat dissipation properties can be reliably improved.

Similar to Example 1, because the heat dissipating base portion 54 is formed such that the thickness t1 of a portion corresponding to the solar cell element 11 is increased relative to the thickness st2 of a portion away from the solar cell element 11, the heat resistance of the heat dissipation path can be reliably reduced, so it is possible to obtain a concentrating solar power generation unit 40 having even higher heat dissipation properties.

It is also possible to adopt a configuration in which an appropriate step portion 54s is formed between the receiver substrate 20 (base 21) and the heat dissipating base portion 54, and the step portion 54s is fitted into a fitting through hole 47i formed in the solar cell mounting plate 47. This configuration can facilitate positioning when mounting the solar cell 10A onto the solar cell mounting plate 47, improving productivity.

As described above, in Example 2, because the receiver substrate 20 and the heat dissipating base portion 54 are integrated, the solar cell 10A includes a radiator 53 that includes a heat dissipating base portion 54 integrated with the base 21 and heat dissipating projection portions 55 projecting from the heat dissipating base portion 54.

### <Embodiment 5>

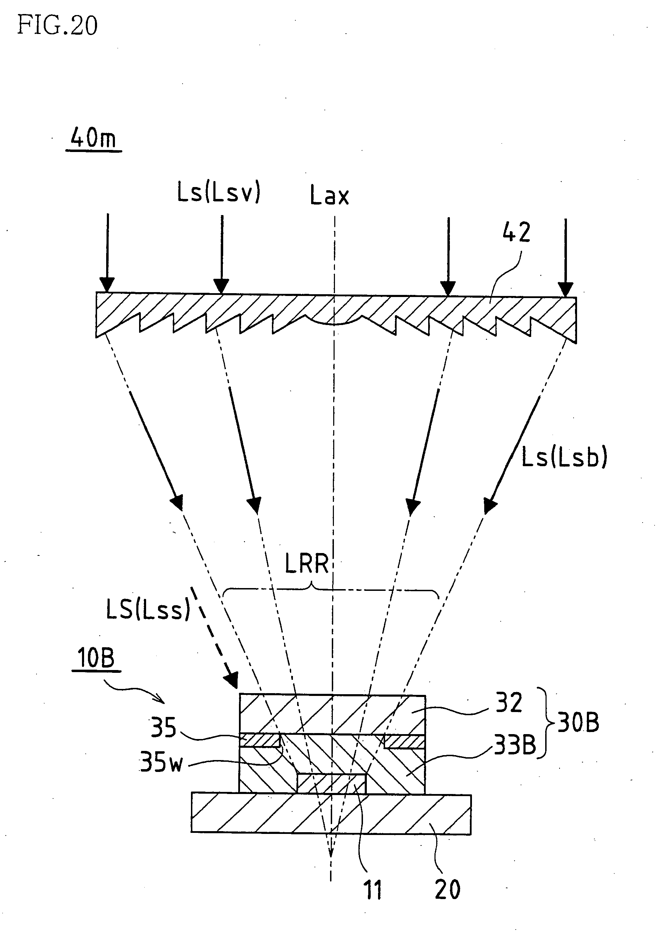

A solar cell, a method of manufacturing a solar cell and a concentrating solar power generation module according to Embodiment 5 of the present invention will be described with reference to FIG. 20.

FIG. 20 is a cross-sectional view showing a configuration of a solar cell and a concentrating solar power generation module according to Embodiment 5 of the present invention.

A solar cell 10B according to Embodiment 5 includes a solar cell element 11 that converts sunlight Ls (sunlight Lsb) concentrated by a concentrating lens 42 into electricity, a receiver substrate 20 on which the solar cell element 11 is placed, a resin sealing portion 33B that seals the solar cell element 11 with resin, and a light-transmitting covering plate 32 that has a reflecting portion 35 on the face facing the resin sealing portion 33B.

The solar cell element 11 is made of an inorganic material, such as Si, GaAs, CuInGaSe or CdTe. The structure of the solar cell element 11 can be any of various structures, such as a single-junction cell, a monolithic multijunction cell, and a mechanical stack in which various solar cells having different wavelength sensitivity ranges are connected.

It is desirable that the outer size of the solar cell element 11 is approximately several to 20 mm from the viewpoint of achieving a reduction in the amount of solar cell material used, the cost of processing, the ease of processing, simplification of the process, and the like.

In order to reduce the light reflection coefficient in the wavelength sensitivity range of the solar cell element 11, a suitable anti-reflection film or the like may be provided on the surface of the solar cell element 11. Furthermore, a UV reflective film, an infrared reflective film or the like that reflects light of a wavelength other than the wavelength sensitivity range of the solar cell element 11 may be provided.

In the receiver substrate 20, desired wiring (a connection pattern that is connected to the electrodes (not shown) of the solar cell element 11 and that performs output to the outside, or a connection pattern for connecting solar cells 10B in series or in parallel, not shown) is formed on a base such as an aluminum plate or copper plate with an appropriate insulating layer interposed therebetween.

In other words, a configuration is adopted in which the current generated by the solar cell element 11 is outputted to the outside of the solar cell 10B with the wiring formed in the receiver substrate 20 as appropriate. Because the wiring formed in the receiver substrate 20 is required to secure highly reliable insulation capabilities, a configuration, for example, is adopted in which insulation is provided by covering the connection pattern formed of a copper foil with an insulating film such as an organic material.

The light-transmitting covering plate 32 is formed of, for example, a glass plate to secure heat resistance and moisture resistance, improving weather resistance. The light-transmitting covering plate 32 is configured to have a thickness that can suppress the irradiation intensity of sunlight Lsb at the concentrating lens 42-side surface to, for example, approximately 310 kW/m² or less so as to secure heat resistance.

The resin sealing portion 33B is configured with an insulating resin, such as a transparent silicone resin, filled between the solar cell element 11 and the light-transmitting covering plate 32 to cause the sunlight Ls that has passed through the light-transmitting covering plate 32 to be directed to the solar cell element 11. In Embodiment 5, the covering portion 30B is configured from the light-transmitting covering plate 32 and the resin sealing portion 33B.

The concentrating lens 42 is configured so as to exactly face the sun by the action of a sun-tracking mechanism (not shown). Accordingly, sunlight Ls enters perpendicularly (the direction parallel to the optical axis Lax of the optical system) to the incident face of the concentrating lens 42 as sunlight Lsv. Also, the concentrating lens 42 is configured to concentrate sunlight Lsb, which is refracted sunlight Lsv, on the solar cell element 11. Hereinafter, the sunlight Lsv and the sunlight Lsb are each referred to simply as sunlight Ls, where it is unnecessary to distinguish them.

The solar cell 10B includes a reflecting portion 35 that prevents irradiation of the receiver substrate 20 from sunlight Ls on the face of the light-transmitting covering plate 32, facing the resin sealing portion 33B. In the reflecting portion 35, a light-transmitting window 35w having a shape similar to the shape of the solar cell element 11 (effective light-receiving face region) is formed in a region corresponding to an optical path range LRR of concentrated sunlight Lsb. Accordingly, when the concentrating lens 42 (sunlight Ls) is in a normal position, sunlight Lsb is reliably concentrated on the solar cell element 11.

A configuration is adopted in which sunlight Ls is concentrated on the solar cell element 11 by a sun-tracking mechanism, but there are cases in which, for example, the position shifts due to the occurrence of a sun tracking error or alignment error in the optical system, shifting the light concentration spot. That is, deviated sunlight Lss may be directed to the solar cell 10B. Hereinafter, shifting of the light concentration spot due to a sun tracking error, alignment error, variation of light intensity or the like will be sometimes described simply as shifting due to a sun tracking error (sun tracking error, etc).

The reflecting portion 35 is disposed so as to correspond to the outside of the normal optical path range LRR set for the sunlight Lsb concentrated on the solar cell element 11 (effective light-receiving face region), so even if sunlight Lss occurs, the reflecting portion 35 can reflect the sunlight Lss. Hereinafter, the sunlight Lss may also be referred to simply as sunlight Ls, where it is unnecessary to distinguish between the sunlight Lss and the sunlight Lsv, the sunlight Lsb.

Accordingly, even if the concentrated sunlight Ls (sunlight Lsb) is shifted due to, for example, a sun tracking error or the like, and the sunlight Lss is directed to a position shifted from the position of the solar cell element 11 (effective light-receiving face region), irradiation of the receiver substrate 20 from the sunlight Ls (sunlight Lss) can be prevented. That is, because irradiation of the receiver substrate 20 from the sunlight Ls can be prevented, the temperature increase at the surface of the receiver substrate 20 is suppressed, preventing burnout of the members disposed on the surface of the receiver substrate 20.

Because the wiring formed on the surface of the receiver substrate 20 is configured from an organic member having a low heat resistance, or the like, as already described above, if sunlight Lss is directed, damage to the organic member may occur, which in turn may cause damage to the wiring, decreasing the reliability of the solar cell 10B. However, provision of the reflecting portion 35 can prevent sunlight Lss from being directed directly to the receiver substrate 20 (wiring), so damage on the wiring and the like can be avoided.

Accordingly, with the reflecting portion 35, even in the case of a high concentration magnification such as 600 SUN (1 SUN = 1 kW/m²) or more, it is possible to prevent the wiring (organic member) and the like of the receiver substrate 20 from being burnt, and the glass constituting the light-transmitting covering plate 32 from being broken, so a highly efficient and inexpensive solar cell 10B having improved heat resistance, good reliability and good weather resistance can be obtained.

The reflecting portion 35 can effectively reflect sunlight Lss by being formed from, for example, a metallic film. By forming the reflecting portion 35 using a metallic film, a reflecting portion 35 having superior reflectivity can be formed readily and inexpensively with good mass productivity.

Because it is sufficient that the reflecting portion 35 is provided only on a face of the light-transmitting covering plate 32, facing the resin sealing portion 33B, and no other members are necessary, it can be formed inexpensively. In addition, because excessive sunlight Ls (sunlight Lss) will not be directed to the receiver substrate 20, the temperature increase that causes decreased efficiency in the solar cell element 11 can be suppressed (reduced). That is, the temperature increase is reduced to prevent burnout of the members disposed on the receiver substrate 20, and the like, so heat resistance is improved and lowering of the power generation amount is prevented.

A method of manufacturing the solar cell 10B will be described next.

First, a light-transmitting covering plate 32 (glass) is prepared (light-transmitting covering plate preparation step). Next, for example, an aluminum film is formed on a face of the light-transmitting covering plate 32, facing the resin sealing portion 33B by a vacuum deposition method (metallic film forming step). That is, the reflecting portion 35 can be formed as an aluminum film. The degree of vacuum during deposition can be, for example, 1×10⁻⁶ Torr, and the thickness of the formed film is approximately 3 µm.

In order to simplify the process to reduce costs while improving the adhesion with the light-transmitting covering plate 32 (glass), it is desirable that the aluminum film is a monolayer film. However, it is also possible to form the aluminum film as a multilayer film having two layers or more.

As the method of forming the metallic film, a sputtering method, a plating method or the like can be used other than a vacuum deposition method. It is, however, desirable to use a vapor deposition method from the viewpoint of ease, safety, mass productivity and the like.

By heat treating the light-transmitting covering plate 32 on which a metallic film (aluminum film) is formed in an oven having a nitrogen atmosphere (or an air atmosphere can be used) at 450°C for 30 minutes, a reflecting portion 35 that prevents irradiation of the receiver substrate 20 from sunlight Ls is formed (metallic film heat treatment step). After heat treatment, the temperature is slowly decreased from the heat treatment temperature to 200°C at a slow cooling rate of 15°C/min, and then to room temperature. Through doing this, cracking of the light-transmitting covering plate 32 can be prevented, and the reflecting portion 35 can be formed in a stable manner.

It is desirable that the heat treatment temperature of the metallic film is at least 400°C or more because when the temperature is less than 400°C, the adhesion strength between the metallic film (reflecting portion 35) and the glass (light-transmitting covering plate 32) will not be sufficient. When the temperature is high, close to the softening point of the glass, the glass may crack, so it is desirable that the treatment temperature is, although the softening point depends on the type of glass, 800°C or less as a general value. That is, it is desirable that the treatment temperature of the metallic film is 450°C or more and 800°C or less.

The heat treatment time is also an important control factor. When the heat treatment time is less than 5 minutes, a heat treatment effect was not obtained in terms of heat capacity. Conversely, a heat treatment time of over 50 minutes results in an excessive heat treatment, and discoloration of the aluminum film or the like may occur, consuming unnecessary energy. Accordingly, it is desirable that the heat treatment time is 5 minutes or more and 50 minutes or less.

The cooling rate after heat treatment is also an important control factor. Rapid cooling can cause cracking in glass except for special glasses such as quartz glass. Accordingly, it is desirable to perform cooling from the heat treatment temperature to 200°C at a slow cooling rate of 20°C/min or less.

After that, the position of the light-transmitting covering plate 32 relative to the receiver substrate 20 is determined based on the relationship between the optical path range LRR and the solar cell element 11, and sealing resin is filled between the receiver substrate 20 and the light-transmitting covering plate 32 so as to form a resin sealing portion 33B, thereby resin-sealing the solar cell 10B (resin sealing step)

In the solar cell 10B manufactured by the above-described manufacturing method, the reflecting portion 35 (glass/aluminum film structure) has a reflection coefficient at a wavelength of 400 nm to 1200 nm measured at the surface of the light-transmitting covering plate 32 (the air/glass interface) of 65% or more. With a reflection coefficient of 60% or more, reflection can be reliably caused.

In other words, when the reflection coefficient is less than 60%, in the case of a high concentration magnification, because the sunlight Ls heats the receiver substrate 20 and the like, raising the temperature, burnout of the members disposed on the surface of the receiver substrate 20, cracking of the glass, or the like may occur through the influence of the temperature increase, whereas when the reflection coefficient is 60% or more, it is possible to prevent irradiation of the receiver substrate 20 from sunlight Ls, and to reliably prevent a temperature increase in the receiver substrate 20.

Instead of aluminum, it is also possible to use silver under the same conditions. By forming the metallic film using aluminum or silver, a reflecting portion 35 having superior reflectivity can be formed readily with high accuracy and good mass productivity at a low cost.

The patterning of aluminum film for forming a light-transmitting window 35w can be performed using an appropriate etching solution after the metallic film forming step (or the metallic film heat treatment step). It is also possible to form a metallic film by performing patterning using an appropriate mask corresponding to the light-transmitting window 35w simultaneously with the vapor deposition in the metallic film forming step. The processing of the planar dimension of the light-transmitting covering plate 32 (planar dimension formation) can be performed appropriately such as before the metallic film forming step, or after the metallic film heat treatment step.

As described above, a method of manufacturing a solar cell 10B according to Embodiment 5 relates to a method of manufacturing a solar cell that includes a solar cell element 11 that converts sunlight Ls concentrated by a concentrating lens 42 into electricity, a receiver substrate 20 on which the solar cell element 11 is placed, a resin sealing portion 33B that seals the solar cell element 11 with resin, a light-transmitting covering plate 32 that covers the resin sealing portion 33B, and a reflecting portion 35 that is formed on a face facing the resin sealing portion 33B of the light-transmitting covering plate 32 and that prevents irradiation of the receiver substrate 20 from sunlight Ls, and the method involves the following steps.

Specifically, the method involves a light-transmitting covering plate preparation step of preparing a light-transmitting covering plate 32, a metallic film forming step of forming a metallic film on a face facing the resin sealing portion 33B of the light-transmitting covering plate 32, a metallic film heat treatment step of heat treating the metallic film to form a reflecting portion 35 that prevents irradiation of the receiver substrate 20 from sunlight Ls, and a resin sealing step of forming a resin sealing portion 33B in a state in which the light-transmitting covering plate 32 in which a reflecting portion 35 is formed is disposed facing the solar cell element 11.

With this configuration, a reflecting portion 35 having superior reflectivity can be formed readily with high accuracy and good mass productivity at a low cost, so a highly reliable solar cell 10B that has superior heat resistance can be manufactured with good productivity.

A concentrating solar power generation module 40m according to Embodiment 5 includes a concentrating lens 42 that receives and concentrates sunlight Ls (sunlight Lsv), and a solar cell element 11 (solar cell 10B) that converts the sunlight Ls (sunlight Lsb) concentrated by the concentrating lens 42 into electricity.

With this configuration, because a solar cell 10B having superior heat resistance is included, it is possible to form a concentrating solar power generation module 40m having improved heat resistance and high reliability.

For the solar cell element 11 used in the concentrating solar power generation module 40m, because it is required to have high efficiency and practical usefulness in particular, it is desirable to use a InGaP/GaAs/Ge triple-junction solar cell element, a AlGaAs/Si solar cell element, or a monolithic multijunction solar cell element.

In order to effectively perform the light concentration of the concentrating lens 42, the surface of the solar cell element 11 that converts sunlight Ls into electricity is disposed in parallel with the incident face of the concentrating lens 42, the incident face and emitting face of the light-transmitting covering plate 32.

The concentrating lens 42 is configured so as to have a focal position FP on the optical axis Lax on the back face side of the solar cell element 11. The focal position FP for each wavelength of sunlight Ls is positioned on the optical axis Lax.

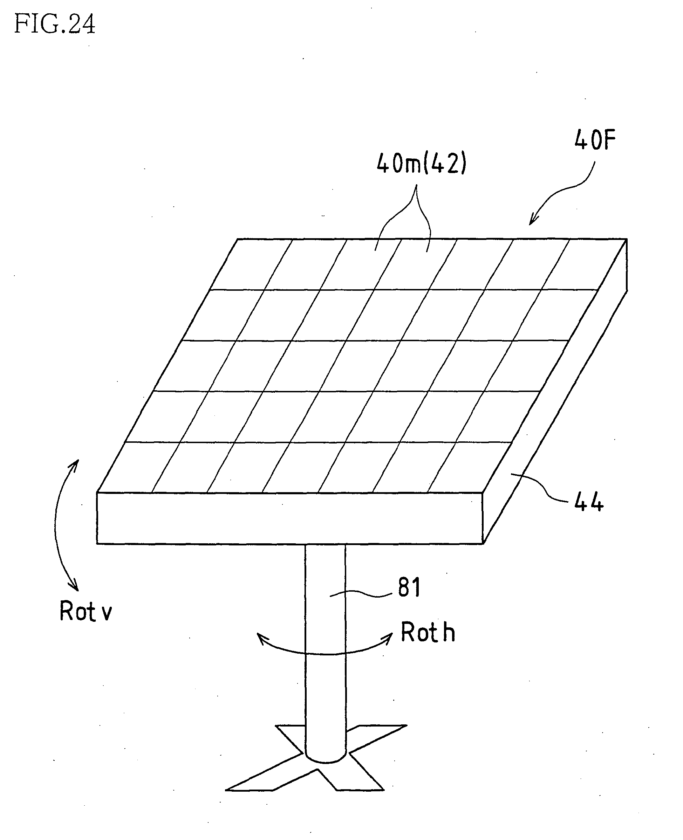

The concentrating lens 42 can be a biconvex lens, a planoconvex lens, a Fresnel lens or the like. From the viewpoint of weight, cost, and ease of handling in an operating environment, it is desirable that the incident face that receives sunlight Ls (sunlight Lsv) is flat, and that the emitting face from which the sunlight Ls (sunlight Lsb) is directed to the solar cell element 11 has the shape of a Fresnel lens having a substantially triangular cross section. The concentrating lens 42 can also be configured by arranging a plurality of the same optical systems in an array to form a single body (see FIG. 24).

It is preferable that the material for the concentrating lens 42 has a high transmittance at the sensitivity wavelength of light of the solar cell element 11 and weather resistance. For example, it is possible to use a thin plate glass that is generally used in a conventional solar cell module (solar power generation system) or the like, weather resistance grade acrylic resin, polycarbonate or the like. The material for the concentrating lens 42 is not limited to those listed above, and it can be configured from a plurality of layers of these materials. Also, a suitable ultraviolet-absorbing agent can be added to the above materials for the purpose of preventing ultraviolet deterioration of the concentrating lens 42 itself and other members.

### <Embodiment 6>

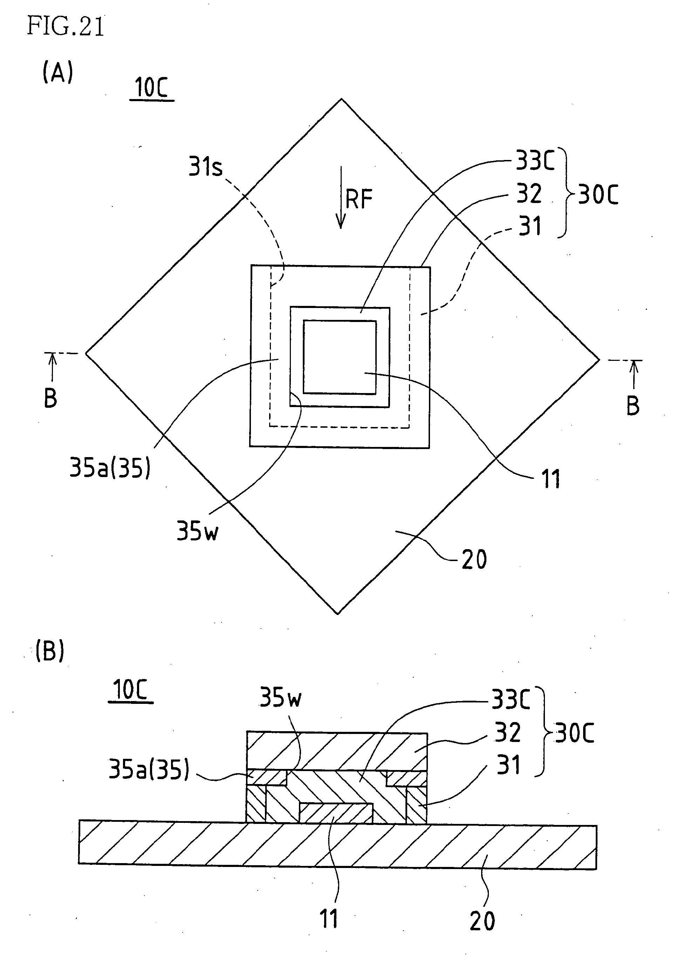

Solar cells and solar cell manufacturing methods according to Embodiment 6 and its variation will be described with reference to FIGS. 21(A) to 22(B). First, a variation of the covering portion 30B and the reflecting portion 35 of the solar cell 10B shown in Embodiment 5 will be described as Embodiment 6. The basic configuration is the same as that of Embodiment 5 and, thus, mainly the differences will be described.

FIGS. 21(A) and 21(B) are explanatory diagrams showing a configuration of a solar cell according to Embodiment 6 of the present invention. FIG. 21(A) is a plan view as viewed from the concentrating lens side, and FIG. 21(B) is a cross-sectional view taken along the line B-B of FIG. 21(A).

A solar cell 10C according to Embodiment 6 includes a solar cell element 11, a receiver substrate 20 on which the solar cell element 11 is placed, and a covering portion 30C that covers the solar cell element 11. The covering portion 30C is configured from a sealing frame 31, a light-transmitting covering plate 32, and a resin sealing portion 33C. The sealing frame 31 defines the position at which the light-transmitting covering plate 32 is placed, and also defines the region in which the resin sealing portion 33C is formed.

In the solar cell 10C shown in FIGS. 21(A) and 21(B), a reflecting portion 35a is sandwiched by the sealing frame 31 and the light-transmitting covering plate 32. With this configuration, a large reflecting portion 35a can be formed. In addition, the height of the sealing frame 31 can be reduced by a length equal to the thickness of the reflecting portion 35a.

The overall process of manufacturing the solar cell 10C will be described.

First, a solar cell element 11 is connected to a receiver substrate 20. The connection is established by die bonding or wire bonding (not shown to simplify the drawings) on the wiring (not shown to simplify the drawings) formed on the receiver substrate 20.

Next, a sealing frame 31 is formed around the solar cell element 11 except for an opening 31s portion (sealing frame forming step). The sealing frame 31 is formed of, for example, a white silicone resin (adhesive). By using the same resin as the resin sealing portion 33C, the adhesion of the covering portion 30C is improved. Also, by using a white resin, temperature increase in the sealing frame 31 itself can be prevented.

The light-transmitting covering plate 32, on which the reflecting portion 35a is formed, covers and is bonded to the sealing frame 31 (covering plate bonding step). That is, the reflecting portion 35a is bonded directly to the sealing frame 31. After being bonded to the sealing frame 31, the light-transmitting covering plate 32 is heat treated, for example, at 150°C for 30 minutes to cure the sealing frame 31.

A space formed by the receiver substrate 20, the sealing frame 31 and the light-transmitting covering plate 32 is filled with sealing resin through the opening 31s in the direction of the arrow RF to form a resin sealing portion 33C (resin sealing step). The sealing resin filled into the resin sealing portion 33C is a transparent silicone resin, as in the case of Embodiment 5. After the sealing resin is filled, a heat treatment is performed, for example, at 150°C for 30 minutes to cure the resin sealing portion 33C.

Through the above-described sealing frame forming step, covering plate bonding step and resin sealing step, a highly reliable covering portion 30C configured from a sealing frame 31, a light-transmitting covering plate 32 having a reflecting portion 35a, and a resin sealing portion 33C can be formed readily with good workability.

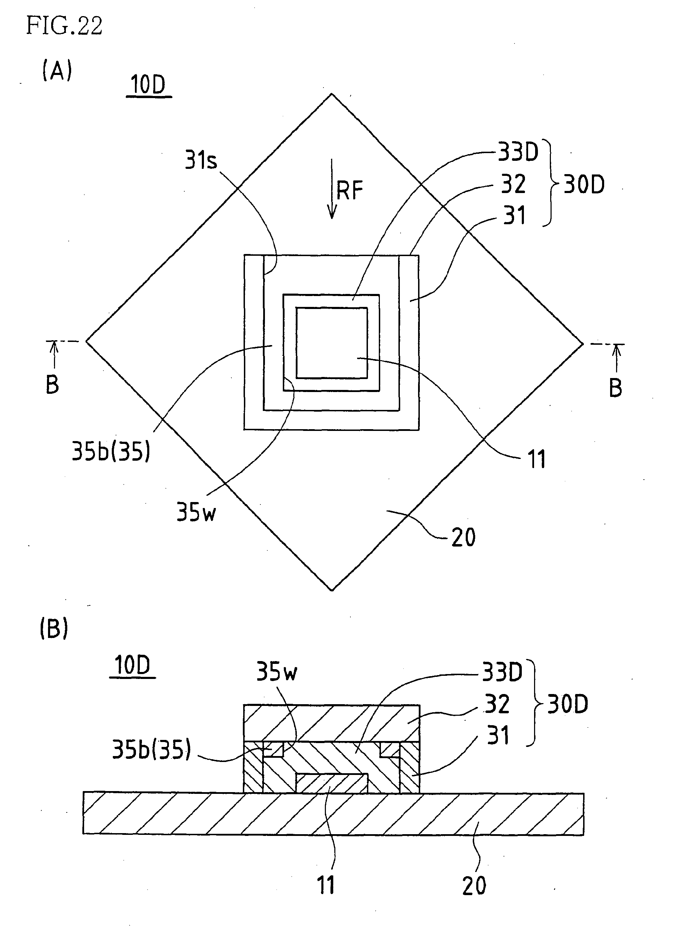

FIGS. 22(A) and 22(B) are explanatory diagrams showing a configuration of a solar cell according to a variation of Embodiment 6 of the present invention, with FIG. 22(A) being a plan view as viewed from the concentrating lens side, and FIG. 22(B) being a cross-sectional view taken along the line B-B of FIG. 22(A).

The basic configuration of a solar cell 10D according to a variation of Embodiment 6 is the same as that of FIGS. 21(A) and 21(B) and, thus, mainly the differences from the solar cell 10C of FIGS. 21(A) and 21(B) will be described. The reflecting portion 35b is formed such that it is enclosed within the sealing frame 31, so the reflecting portion 35b will not overlay on and not be bonded to the sealing frame 31. That is, the sealing frame 31 is bonded directly to the light-transmitting covering plate 32, and the reflecting portion 35b is disposed adjacent to the sealing frame 31.

As shown in FIGS. 21(A) to 22(B), as long as the reflecting portion 35 (35a, 35b) can reflect deviated sunlight Lss, the shape of the reflecting portion 35 (35a, 35b) can be changed as appropriate according to the specification of the solar cell (optical path range LRR, see FIG. 20). In Embodiment 6 and its variation, the reflecting portion 35a and the reflecting portion 35b are formed of a metallic film, as in Embodiment 5.

The solar cells 10C and 10D according to Embodiment 6 and its variation can be applied to the concentrating solar power generation module 40m described in Embodiment 5 without making any modifications.

### <Embodiment 7>

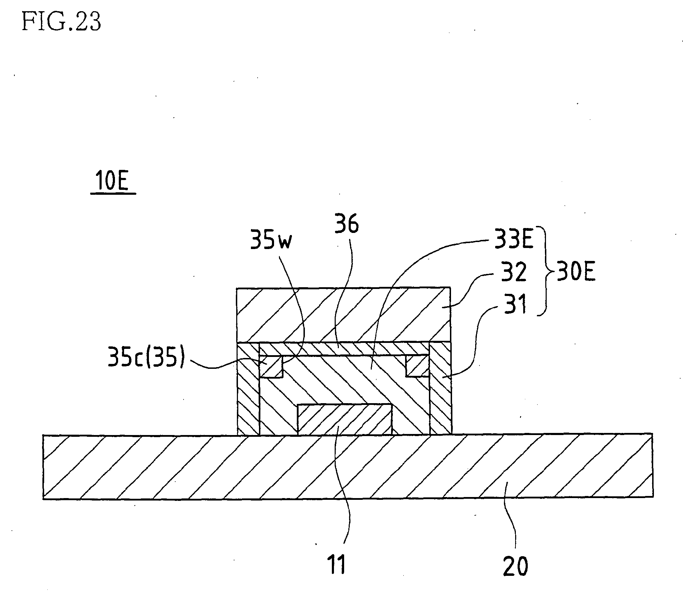

A solar cell and a solar cell manufacturing method according to Embodiment 7 will be described with reference to FIG. 23. A variation of the covering portions 30B, 30C, 30D and the reflecting portion 35 (35a, 35b) of the solar cells 10B, 10C, 10D shown in Embodiments 5 and 6 and the variations thereof will be described as Embodiment 7. The basic configuration is the same as those of Embodiments 5 and 6 and the variations thereof and, thus, mainly the differences will be described.

FIG. 23 is a cross-sectional view showing a configuration of a solar cell according to Embodiment 7 of the present invention.

In a solar cell 10E of Embodiment 7, the reflecting portion 35c (reflecting portion 35) is formed from a metallic plate. By forming the reflecting portion 35c using a metallic plate, a reflecting portion 35c having superior reflectivity can be formed readily and inexpensively with simple steps. That is, the process is simplified, and the reflecting portion 35c is formed readily with high accuracy, so a highly reliable solar cell 10E that has superior heat resistance can be manufactured inexpensively with good productivity. The shape of the metallic plate can be various shapes as in Embodiments 5 and 6. The reflecting portion 35c has the same shape as the reflecting portion 35b shown in FIGS. 22(A) and 22(B).

It is desirable that the material for the metallic plate is aluminum (aluminum plate) or SUS (Steel Use Stainless: stainless steel material, stainless steel plate), considering productivity, safety and reliability. An aluminum alloy can be incorporated into the aluminum. Use of a metallic plate eliminates the need for expensive equipment such as a vacuum deposition apparatus, so the step of forming the reflecting portion 35c can be simplified, improving mass productivity. That is, the reflecting portion 35c can be formed readily and inexpensively with simple steps.

In Embodiment 7, an approximately 0.5 mm thick aluminum plate having a glossy face (mirror finished surface) was used. The resin sealing portion 35 (glass/aluminum plate structure) has a reflection coefficient at a wavelength of 400 nm to 1200 nm measured at the surface of the light-transmitting covering plate 32 (the air/glass interface) of 65% or more. Also, the face facing the concentrating lens 42 can be mirror finished and, thereby, the reflection coefficient can be readily improved.

A method of manufacturing the solar cell 10E of Embodiment 7 will be described next. The method of manufacturing a solar cell according to Embodiment 7 is basically the same as that of Embodiment 5.

Specifically, a method of manufacturing the solar cell 10E according to Embodiment 7 relates to a method of manufacturing a solar cell that includes a solar cell element 11 that converts sunlight Ls concentrated by a concentrating lens 42 into electricity, a receiver substrate 20 on which the solar cell element 11 is placed, a resin sealing portion 33E that seals the solar cell element 11 with resin, a light-transmitting covering plate 32 that covers the resin sealing portion 33E, and a reflecting portion 35c that is formed on a face facing the resin sealing portion 33E of the light-transmitting covering plate 32 and that prevents irradiation of the receiver substrate 20 from sunlight Ls, and the method involves the following steps.

That is, the method involves a light-transmitting covering plate preparation step of preparing a light-transmitting covering plate 32, a metallic plate preparation step of preparing a metallic plate having the shape of a reflecting portion 35c, a metallic plate bonding step of bonding the aluminum plate (metallic plate) to the light-transmitting covering plate 32 to form a reflecting portion 35c, and a resin sealing step of forming a resin sealing portion 33E in a state in which the light-transmitting covering plate 32 in which reflecting portion 35c is formed is disposed facing the solar cell element 11.

With this configuration, a reflecting portion 35c having superior reflectivity can be formed readily with high accuracy in simple steps, so a solar cell 10E can be manufactured inexpensively.

The step (a metallic plate preparation step and a metallic plate bonding step) of forming a reflecting portion 35c in a covering portion 30E (light-transmitting covering plate 32) will be described in further detail.

First, an aluminum plate is prepared as a metallic plate having the shape of a reflecting portion 35c (metallic plate preparation step). The shape of the reflecting portion 35 can be formed by, for example, pressing an aluminum flat plate having a large area using a die.

Next, a bonding portion 36 for bonding an aluminum plate (reflecting portion 35c) to a face of the light-transmitting covering plate 32 facing the solar cell element 11 is formed (adhesive application step). The bonding portion 36 is formed by applying a transparent resin as an adhesive onto at least a region corresponding to the reflecting portion 35c (aluminum plate). The aluminum plate is placed on the bonding portion 36, and is heat treated in an oven at a temperature of approximately 80°C to solidify the bonding portion 36. The reflecting portion 35c is bonded to the bonding portion 36 by the solidification of the bonding portion 36, and is integrated with the light-transmitting covering plate 32 (metallic plate bonding step).

It is desirable that the transparent resin constituting the bonding portion 36 is the same material as the resin sealing portion 33E. Thereby, the adhesion at the interface between the resin sealing portion 33E and the bonding portion 36 is improved, and reflection and refraction at the interface is reduced, so it is possible to prevent the occurrence of distortion caused by a difference in heat capacity.

After preparation of the light-transmitting covering plate 32 on which the reflecting portion 35 is bonded in the metallic plate bonding step, a covering portion 30E (resin sealing portion 33E) is formed in the same manner as described in Embodiment 6. Specifically, a sealing frame 31 is formed in the sealing frame forming step, the light-transmitting covering plate 32 on which the reflecting portion 35c is formed is bonded to the sealing frame 31 in the covering plate bonding step, and a resin sealing portion 33E is formed in the resin sealing step.

Accordingly, in Embodiment 7, an aluminum plate is prepared as a metallic plate for reflecting portion 35c, and the aluminum plate is bonded to the light-transmitting covering plate 32 with an adhesive to form a reflecting portion 35c, so a vacuum deposition apparatus, which is an expensive apparatus, is unnecessary. In addition, the metallic plate preparation step and the metallic plate bonding step are relatively easy steps, so the step of forming a reflecting portion 35c can be simplified, and a solar cell 10E can be manufactured inexpensively with good mass productivity.

The solar cell 10E of Embodiment 7 is applicable to the concentrating solar power generation module 40m described in Embodiment 5 without any modification.

### <Embodiment 8>

A concentrating solar power generation unit according to Embodiment 8 will be described with reference to FIG. 24. The concentrating solar power generation unit of Embodiment 8 is configured by arranging a plurality of concentrating solar power generation modules 40m that include any of the solar cells 10B, 10C, 10D and 10E described in Embodiments 5 to 7.

FIG. 24 is a perspective view schematically illustrating a configuration of a concentrating solar power generation unit according to Embodiment 8 of the present invention.

A concentrating solar power generation unit 40F of Embodiment 8 includes an elongated frame 44 and a plurality of concentrating solar power generation modules 40m arranged along the elongated frame 44. The concentrating solar power generation modules 40m include any of the solar cells 10B, 10C, 10D and 10E described in Embodiments 5 to 7. The concentrating solar power generation module 40m can also take an independent form by being disposed in a single frame that is different from the elongated frame 44.

With this configuration, the concentrating solar power generation unit 40F includes solar cells that have superior heat resistance, so it is possible to improve heat resistance and achieve high reliability.

The concentrating solar power generation modules 40m can be configured to include, for example, an approximately 30 cm-square concentrating lens 42. The concentrating solar power generation unit 40F can be configured to include, for example, 5×1 (five) concentrating solar power generation modules 40m. In this case, the concentrating solar power generation unit 40F forms an approximately 30 cm×150 cm light-receiving face, for example. In order to generate the electric power needed, an appropriate number of concentrating solar power generation modules 40m are connected in series or in parallel. FIG. 24 shows, as an example, a configuration in which seven concentrating solar power generation units 40F are arranged in parallel to form a concentrating solar power generation system (concentrating solar power generation apparatus).

The concentrating solar power generation system (concentrating solar power generation apparatus) configured from a plurality of concentrating solar power generation units 40F is supported by a leg 81, and is configured so as to be automatically driven by a horizontal rotation Rot h and a perpendicular rotation Rot v by a sun-tracking mechanism portion (not shown) so as to track the sun, and to face the concentrating lens 42 [incident face) disposed on the surface of the concentrating solar power generation module 40m toward the direction perpendicular to sunlight Ls.

Accordingly, the concentrating solar power generation unit 40F of Embodiment 8 is applicable to a concentrating solar power generation system with a high concentration magnification. In other words, with the concentrating solar power generation module 40m of the present invention, it is possible to configure a highly efficient and inexpensive sun-tracking concentrating solar power generation system that has good reliability and good weather resistance.

Even if sun-tracking fails due to a sun tracking error or the like, the solar cells will not burn out, so a highly reliable sun-tracking concentrating solar power generation system can be obtained.

The sun-tracking mechanism portion (sun-tracking driving system) is configured from a sun-tracking driving apparatus having two different axes: an azimuth axis for moving the concentrating lens 42 (incident face) to face toward the orientation of the sun; and an inclining axis for inclining the concentrating lens 42 (incident face) according to the altitude of the sun, so, it is possible to track the sun with high accuracy.

As the power system of the sun-tracking driving system, there are methods such as a method of driving the sun-tracking driving system in a predetermined direction by rotating a gear a predetermined number of times using a motor and a decelerator, and a method of driving the sun-tracking driving system in a predetermined direction by adjusting a cylinder to a predetermined length using a hydraulic pump and a hydraulic cylinder. Either method can be used.

As the sunlight sun-tracking method, the following methods are known: a method in which the orbit of the sun is calculated in advance by a clock that controls the operation of the sun-tracking driving system, which is included inside the sun-tracking driving system, and control is exerted so as to move the concentrating solar power generation module 40m (concentrating solar power generation unit 40F) to face the orientation of the sun; and a method in which a solar sensor made of a photodiode or the like is attached to the sun-tracking driving system, and control is exerted so as to constantly monitor the direction of the sun; and either method can be used.

The present invention may be embodied in various other forms without departing from the gist or essential characteristics thereof. Therefore, the embodiments disclosed in this application are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority from Japanese Patent Application No. 2006-265167 filed in Japan on September 28, 2006; Japanese Patent Application No. 2006-268191 filed in Japan on September 29, 2006; and Japanese Patent Application No. 2007-022026 filed in Japan on January 31, 2007; the entire contents of which are hereby incorporated by reference. Furthermore, the entire contents of references cited in the present specification are herein specifically incorporated by reference.

## Claims

1. A solar cell comprising: a solar cell element that converts sunlight into electricity; a receiver substrate on which the solar cell element is placed; and a covering portion that covers the solar cell element,
wherein the covering portion comprises:
a sealing frame that is formed on a surface of the receiver substrate, has an opening, and surrounds the periphery of the solar cell element;
a light-transmitting covering plate that is bonded to the sealing frame and covers the solar cell element; and
a resin sealing portion in which a sealing region defined by the sealing frame and the light-transmitting covering plate is filled with sealing resin.

2. The solar cell according to claim 1,
wherein the light-transmitting covering plate is a glass plate.

3. The solar cell according to claim 1 or 2,
wherein the light-transmitting covering plate has a thickness that can suppress irradiation intensity at a surface of the light-transmitting covering plate to 310 kW/m² or less.

4. The solar cell according to claim 1 or 2,
wherein the sealing frame is formed of a white silicone resin.

5. A method of manufacturing a solar cell comprising: a solar cell element that converts sunlight into electricity; a receiver substrate on which the solar cell element is placed; and a covering portion that covers the solar cell element,
wherein a covering portion forming step of forming the covering portion comprises:
a sealing frame forming step of forming a sealing frame having an opening on the receiver substrate such that the sealing frame surrounds the periphery of the solar cell element;
a covering plate bonding step of bonding a light-transmitting covering plate that covers the solar cell element to the sealing frame; and
a resin sealing step of filling a sealing region defined by the sealing frame and the light-transmitting covering plate with sealing resin through the opening to form a resin sealing portion.

6. The method of manufacturing a solar cell according to claim 5, wherein the covering plate bonding step comprises:
a covering plate placing step of placing the light-transmitting covering plate on a covering plate bonding jig;
a sealing frame bonding step of placing the receiver substrate on which the sealing frame is formed on the covering plate bonding jig and bonding the light-transmitting covering plate to the sealing frame; and
a heat treatment step of heat treating the covering plate bonding jig on which the light-transmitting covering plate and the receiver substrate are placed in a heat treatment furnace.

7. The method of manufacturing a solar cell according to claim 6,
wherein the covering plate bonding jig is configured to define a height of the covering portion with a step between a covering plate placing portion on which the light-transmitting covering plate is placed and a receiver substrate placing portion on which the receiver substrate is placed.

8. The method of manufacturing a solar cell according to claim 5, wherein the resin sealing step comprises:
a substrate juxtaposing step of juxtaposing the receiver substrate in a substrate juxtaposition jig with the opening being positioned horizontally in an upper portion of the sealing frame;
a resin filling step of filling a sealing region with sealing resin through the opening of the receiver substrate juxtaposed in the substrate juxtaposition jig with a resin injector; and
a heat treatment step of heat treating the substrate juxtaposition jig on which the receiver substrate filled with the sealing resin is placed in a heat treatment furnace.

9. The method of manufacturing a solar cell according to claim 8,
wherein the substrate juxtaposition jig is configured such that the receiver substrate is juxtaposed in an inclined state relative to the perpendicular direction.

10. The method of manufacturing a solar cell according to claim 8 or 9,
wherein the resin injector is disposed such that the resin injector fills with the sealing resin at a position shifted from the center of the opening.

11. A solar cell manufacturing apparatus that fills a sealing region defined by a sealing frame surrounding the periphery of a solar cell element placed on a receiver substrate and a light-transmitting covering plate bonded to the sealing frame with sealing resin so as to form a resin sealing portion, the apparatus comprising:
a substrate juxtaposition jig in which a plurality of the receiver substrates to which the light-transmitting covering plate is bonded by the sealing frame are juxtaposed with an opening of the sealing frame being positioned in an upper portion of the sealing frame; and
a resin injector that fills the sealing region with sealing resin through the opening.

12. The solar cell manufacturing apparatus according to claim 11,
wherein the resin injector is configured to move in a perpendicular direction, and the substrate juxtaposition jig is configured to move at an equal pitch in a horizontal direction.

13. A solar cell comprising: a solar cell element including a substrate electrode and a surface electrode; and a receiver substrate on which the solar cell element is placed,
wherein the receiver substrate includes a base, an intermediate insulating layer laminated on the base, and a connection pattern layer laminated on the intermediate insulating layer, and
the substrate electrode and the surface electrode are each connected to the connection pattern layer.

14. The solar cell according to claim 13, comprising
a surface protection layer that protects the connection pattern layer.

15. The solar cell according to claim 13 or 14,
wherein the receiver substrate and the solar cell element each have a rectangular shape, and the solar cell element is disposed such that each side intersects a diagonal line of the receiver substrate.

16. The solar cell according to claim 13 or 14,
wherein the surface electrode is formed at four corners of the solar cell element, and each is connected to the connection pattern layer with a wire.

17. The solar cell according to claim 13 or 14, comprising a radiator that includes a heat dissipating base portion integrated with the base and a heat dissipating projection portion projected from the heat dissipating base portion.

18. A concentrating solar power generation unit comprising: a solar cell including a solar cell element and a receiver substrate on which the solar cell element is placed; and a solar cell mounting plate on which the receiver substrate is mounted,
wherein a radiator is disposed on a back face side of the receiver substrate that is opposite to a surface side on which the solar cell element is placed so as to correspond to the solar cell element.

19. The concentrating solar power generation unit according to claim 18,
wherein the radiator comprises: a heat dissipating base portion that contacts the solar cell mounting plate on a back face side of the solar cell mounting plate that is opposite to a surface side on which the receiver substrate is mounted; and a heat dissipating projection portion projected from the heat dissipating base portion.

20. The concentrating solar power generation unit according to claim 18,
wherein the radiator comprises a heat dissipating base portion integrated with the receiver substrate and a heat dissipating projection portion projected from the heat dissipating base portion.

21. The concentrating solar power generation unit according to claim 19 or 20,
wherein the heat dissipating base portion is configured such that a thickness of a portion corresponding to the solar cell element is increased relative to a thickness of a portion away from the solar cell element.

22. A solar cell comprising: a solar cell element that converts sunlight concentrated by a concentrating lens into electricity; a receiver substrate on which the solar cell element is placed; a resin sealing portion that seals the solar cell element with resin; and a light-transmitting covering plate that covers a concentrating lens side face of the resin sealing portion,
wherein the solar cell comprises a reflecting portion that prevents irradiation of the receiver substrate from sunlight on a face facing the resin sealing portion of the light-transmitting covering plate.

23. The solar cell according to claim 22,
wherein the reflecting portion is a metallic film.

24. The solar cell according to claim 23,
wherein the metallic film is formed using aluminum or silver.

25. The solar cell according to claim 22,
wherein the reflecting portion is a metallic plate.

26. The solar cell according to claim 25,
wherein the metallic plate is an aluminum plate or a stainless steel plate.

27. The solar cell according to any one of claims 22 to 26,
wherein the reflecting portion has a reflection coefficient at a wavelength of 400 nm to 1200 nm measured at a surface of the light-transmitting covering plate of 60% or more.

28. A concentrating solar power generation module comprising: a concentrating lens that concentrates sunlight; and a solar cell that converts sunlight concentrated by the concentrating lens into electricity,
wherein the solar cell is the solar cell according to any one of claims 22 to 26.

29. A concentrating solar power generation unit comprising: an elongated frame; and a plurality of concentrating solar power generation modules arranged along the elongated frame,
wherein the concentrating solar power generation module is the concentrating solar power generation module according to claim 28.

30. A method of manufacturing a solar cell comprising: a solar cell element that converts sunlight concentrated by a concentrating lens into electricity; a receiver substrate on which the solar cell element is placed; a resin sealing portion that seals the solar cell element with resin; a light-transmitting covering plate that covers the resin sealing portion; and a reflecting portion that is formed on a face facing the resin sealing portion of the light-transmitting covering plate and that prevents irradiation of the receiver substrate from sunlight, the method comprising:
a light-transmitting covering plate preparation step of preparing the light-transmitting covering plate;
a metallic film forming step of forming a metallic film on a face facing the resin sealing portion of the light-transmitting covering plate;
a metallic film heat treatment step of heat treating the metallic film to form the reflecting portion that prevents irradiation of the receiver substrate from sunlight; and
a resin sealing step of forming the resin sealing portion in a state in which the light-transmitting covering plate in which the reflecting portion is formed is disposed facing the solar cell element.

31. A method of manufacturing a solar cell comprising: a solar cell element that converts sunlight concentrated by a concentrating lens into electricity, a receiver substrate on which the solar cell element is placed, a resin sealing portion that seals the solar cell element with resin, a light-transmitting covering plate that covers the resin sealing portion, and a reflecting portion that is formed on a face facing the resin sealing portion of the light-transmitting covering plate and that prevents irradiation of the receiver substrate from sunlight, the method comprising:
a light-transmitting covering plate preparation step of preparing the light-transmitting covering plate;
a metallic plate preparation step of preparing a metallic plate having a shape of the reflecting portion;
a metallic plate bonding step of bonding the metallic plate to the light-transmitting covering plate to form the reflecting portion; and
a resin sealing step of forming the resin sealing portion in a state in which the light-transmitting covering plate in which the reflecting portion is formed is disposed facing the solar cell element.
